(19) Europäisches Patentamt
European Patent Office
Office européen des brevets

(11) EP 4 283 894 A1

(12) EUROPEAN PATENT APPLICATION
published in accordance with Art. 153(4) EPC

(43) Date of publication:
29.11.2023 Bulletin 2023/48

(21) Application number: 22758767.2

(22) Date of filing: 11.02.2022

(51) International Patent Classification (IPC):
H04L 1/00 (2006.01)    G10L 19/00 (2013.01)

(52) Cooperative Patent Classification (CPC):
G10L 19/00; H04L 1/00

(86) International application number:
PCT/CN2022/075987

(87) International publication number:
WO 2022/179402 (01.09.2022 Gazette 2022/35)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 24.02.2021 CN 202110206769
06.04.2021 CN 202110376449

(71) Applicant: Huawei Technologies Co., Ltd.
Shenzhen, Guangdong 518129 (CN)
(72) Inventors:
• WANG, Sihai
  Shenzhen, Guangdong 518129 (CN)
• LI, Xueru
  Shenzhen, Guangdong 518129 (CN)
• QIN, Cheng
  Shenzhen, Guangdong 518129 (CN)
• YANG, Rui
  Shenzhen, Guangdong 518129 (CN)

(74) Representative: Körber, Martin Hans
Mitscherlich PartmbB
Patent- und Rechtsanwälte
Karlstraße 7
80333 München (DE)

(54) INFORMATION ENCODING CONTROL METHOD AND RELATED APPARATUS

(57) Embodiments of this application provide an information encoding control method, applied to a terminal in the field of communication technologies. The method includes: receiving first configuration information, where the first configuration information is used to configure N groups of parameters of N AI encoders or an AI decider, and the AI decider is configured to determine an AI encoder that is in the N AI encoders and to which first information is applicable, and/or is configured to determine that none of the N AI encoders is applicable to encoding the first information; and sending first indication information to a network device, where the first indication information indicates that a first encoder is used for encoding the first information, the first encoder is determined based on the first configuration information and the first information, and the first encoder is an encoder in the N AI encoders, or is a second encoder different from the N AI encoders. In embodiments of this application, an applicable encoder can be quickly and efficiently selected, to avoid distortion after to-be-transmitted information is encoded and decoded, and improve transmission quality.

FIG. 5

## Description

This application claims priorities to Chinese Patent Application No. 202110206769.9, filed with the China National Intellectual Property Administration on February 24, 2021 and entitled "CONTROL METHOD, TERMINAL, AND NETWORK DEVICE", and to Chinese Patent Application No. 202110376449.8, filed with the China National Intellectual Property Administration on April 6, 2021 and entitled "INFORMATION ENCODING CONTROL METHOD AND RELATED APPARATUS", which are incorporated herein by reference in their entireties.

## TECHNICAL FIELD

This application relates to the field of communication technologies, and in particular, to an information encoding control method and a related apparatus.

## BACKGROUND

In a wireless communication system, some measurement information, status information, and the like are usually transmitted between two devices, to implement subsequent signal transmission. This can improve performance of the communication system. For example, the two devices may be a sending device (for example, a base station) that sends a signal and a receiving device (for example, a terminal) that receives the signal. The receiving device may feed back channel state information (channel state information, CSI) to the sending device, and the sending device may perform, based on the CSI, precoding in a multi-antenna system on a to-be-transmitted radio signal. A precoded radio signal can resist channel distortion and improve a channel capacity. However, amounts of the measurement information, the status information, and the like are usually large. Therefore, encoding or compression usually needs to be performed before transmission, to save air interface resources and reduce transmission overheads.

The base station may send an artificial intelligence (artificial intelligence, AI) model (AI encoder for short) for information encoding to the terminal. The terminal may encode to-be-transmitted information (for example, the measurement information and the status information) by using the AI encoder, and feed back encoded information to the base station. The base station obtains, through decoding by using an AI decoder corresponding to the AI encoder, the information (for example, the measurement information and status information) reported by the terminal. However, a generalization problem exists between the data-driven AI encoder and AI decoder. If the to-be-transmitted information and data for training the AI encoder and the corresponding AI decoder are not identically distributed, the to-be-transmitted information may be distorted after AI encoding and AI decoding. This affects performance of the communication system.

## SUMMARY

Embodiments of this application disclose an information encoding control method and a related apparatus, to quickly and efficiently select an appropriate information encoding solution, avoid distortion after to-be-transmitted information is encoded and decoded, avoid impact on performance of a communication system, and improve transmission quality.

According to a first aspect, embodiments of this application provide an information encoding control method, applied to a terminal. The method includes: receiving first configuration information, where the first configuration information is used to configure N groups of parameters of N AI encoders, and N is a positive integer greater than 1; and sending first indication information to a network device, where the first indication information indicates that a first encoder is used for encoding first information, the first encoder is determined based on the N groups of parameters and the first information, and the first encoder is an encoder in the N AI encoders, or the first encoder is a second encoder different from the N AI encoders.

N groups of parameters of N AI encoders may be replaced with N groups of parameters of N AI decoders, or may be replaced with N groups of parameters of N AI codecs. The N AI encoders respectively correspond to N AI decoders, and one AI codec includes one AI encoder and one corresponding AI decoder.

Optionally, the second encoder is an encoder based on a conventional encoding solution such as a codebook, or another AI encoder with better generalization.

In this application, the first encoder used for encoding the first information is determined based on the N groups of parameters, and the first encoder is one of the N AI encoders or the second encoder different from the N AI encoders. It may be understood that the first encoder used for encoding the first information is determined to be applicable to encoding the first information. This avoids uncontrollable performance deterioration of a communication system and information distortion caused by encoding and decoding the first information by using an AI codec (or an AI encoder and an AI decoder) to which the first information is not applicable.

In a possible implementation, the method further includes: sending second information, where the second information is determined by encoding the first information by the first encoder.

In a possible implementation, the first encoder is determined based on a relationship between a first determining parameter and a first determining threshold, the first determining parameter is determined based on the N groups of parameters and the first information, and the first determining parameter is a cosine similarity CS, a probability density function PDF, a probability mass function PMF, or a Euclidean distance.

Optionally, the first determining parameter is determined based on the N groups of parameters, the first information, and first preprocessing, and the first preprocessing includes at least one of the following: translation, scaling, Fourier transform, compressive sensing transform, truncation, AI model processing, and a corresponding processing parameter.

Optionally, the N groups of parameters are statistical information of training data sets of the N AI encoders, and the statistical information includes a mean and/or a distribution parameter of a mathematical distribution.

In a possible implementation, the first information is channel state information CSI or uplink data.

Optionally, the first information is CSI, and the method further includes: receiving a CSI-reference signal CSI-RS, where the first information is determined based on a measurement result of the CSI-RS.

In a possible implementation, the method further includes: sending second indication information to the network device, where the second indication information indicates the first encoder, or indicates that the first encoder in the N AI encoders is applicable to encoding the first information, or indicates that none of the N AI encoders is applicable to encoding the first information; and receiving second configuration information, where the second configuration information is used to configure the first encoder, and the second configuration information is determined based on the second indication information.

Optionally, the second indication information is sent before the second information.

In this application, the first encoder used by the terminal can be obtained by requesting from the network device in real time, and the terminal may not need to store the first encoder in advance. This reduces storage pressure of the terminal.

In a possible implementation, the method further includes: receiving third configuration information, where the third configuration information is used to configure the N AI encoders, and/or the first encoder in the N AI encoders, and/or the second encoder.

Optionally, the third configuration information is received before the second information is sent.

According to a second aspect, embodiments of this application provide another information encoding control method, applied to a terminal. The method includes: receiving first configuration information, where the first configuration information is used to configure an AI decider, the AI decider is configured to determine an AI encoder that is in N AI encoders and to which first information is applicable, and/or is configured to determine that none of the N AI encoders is applicable to encoding the first information, and N is a positive integer greater than 1; and sending first indication information to a network device, where the first indication information indicates that a first encoder is used for encoding the first information, the first encoder is determined based on the AI decider and the first information, and the first encoder is an encoder in the N AI encoders, or the first encoder is a second encoder different from the N AI encoders.

That the AI decider is configured to determine an AI encoder that is in N AI encoders and to which first information is applicable, and/or is configured to determine that none of the N AI encoders is applicable to encoding the first information may be replaced with that the AI decider is configured to determine an AI codec that is in N AI codecs and to which first information is applicable, and/or is configured to determine that none of the N AI codecs is applicable to encoding and decoding the first information; or may be replaced with that the AI decider is configured to determine an AI decoder that is in N AI decoders and to which first information is applicable, and/or is configured to determine that none of the N AI decoders is applicable to decoding the first information. The N AI encoders respectively correspond to N AI decoders, and one AI codec includes one AI encoder and one corresponding AI decoder.

Optionally, the second encoder is an encoder based on a conventional encoding solution such as a codebook, or another AI encoder with better generalization.

In this application, the first encoder used for encoding the first information is determined based on the AI decider, and the first encoder is one of the N AI encoders or the second encoder different from the N AI encoders. It may be understood that the first encoder used for encoding the first information is determined to be applicable to encoding the first information. This avoids uncontrollable performance deterioration of a communication system and information distortion caused by encoding and decoding the first information by using an AI codec (or an AI encoder and an AI decoder) to which the first information is not applicable.

In a possible implementation, the method further includes: sending second information, where the second information is determined by encoding the first information by the first encoder.

In a possible implementation, the first encoder is determined based on an output of the AI decider, and the output of the AI decider is obtained based on the first information and the AI decider.

Optionally, the output of the AI decider is obtained based on first input information and the AI decider, the first input information is obtained after the first information or second preprocessing of the first information, and the second preprocessing includes at least one of the following: translation, scaling, Fourier transform, compressive sensing transform, truncation, AI model processing, and a corresponding processing parameter.

Optionally, the output of the AI decider is obtained by processing first input information by using the AI decider.

Optionally, the output of the AI decider is an output obtained by using first input information as an input of the AI decider.

In a possible implementation, the method further includes: The first information is channel state information CSI or uplink data.

Optionally, the first information is CSI, and the method further includes: receiving a CSI-reference signal CSI-RS, where the first information is determined based on a measurement result of the CSI-RS.

In a possible implementation, the method further includes: sending second indication information to the network device, where the second indication information indicates the first encoder, or indicates that the first encoder in the N AI encoders is applicable to encoding the first information, or indicates that none of the N AI encoders is applicable to encoding the first information; and receiving second configuration information, where the second configuration information is used to configure the first encoder, and the second configuration information is determined based on the second indication information.

Optionally, the second indication information is sent before the second information.

In this application, the first encoder used by the terminal can be obtained by requesting from the network device in real time, and the terminal may not need to store the first encoder in advance. This reduces storage pressure of the terminal.

In a possible implementation, the method further includes: receiving third configuration information, where the third configuration information is used to configure the N AI encoders, and/or the first encoder in the N AI encoders, and/or the second encoder.

Optionally, the third configuration information is received before the second information is sent.

According to a third aspect, embodiments of this application provide still another information encoding control method, applied to a terminal. The method includes: receiving first configuration information, where the first configuration information is used to configure a parameter of a first AI encoder; and sending first indication information to a network device, where the first indication information indicates that a first encoder is used for encoding first information, the first encoder is determined based on the parameter of the first AI encoder and the first information, and the first encoder is the first AI encoder or the first encoder is a second encoder different from the first AI encoder.

N groups of parameters of the first AI encoder may be replaced with N groups of parameters of the first AI decoder, or may be replaced with N groups of parameters of a first AI codec, where the first AI encoder corresponds to a first AI decoder, and the first AI codec includes the first AI encoder and the first AI decoder.

Optionally, the second encoder is an encoder based on a conventional encoding solution such as a codebook, or another AI encoder with better generalization.

In this application, the first encoder used for encoding the first information is determined based on the parameter of the first AI encoder, and the first encoder is the first AI encoder or the second encoder. It may be understood that the first encoder used for encoding the first information is determined to be applicable to encoding the first information. This avoids uncontrollable performance deterioration of a communication system and information distortion caused by encoding and decoding the first information by using an AI codec (or an AI encoder and an AI decoder) to which the first information is not applicable.

In a possible implementation, the method further includes: sending second information, where the second information is determined by encoding the first information by the first encoder.

In a possible implementation, the first encoder is determined based on a relationship between a first determining parameter and a first determining threshold, the first determining parameter is determined based on the parameter of the first AI encoder and the first information, and the first determining parameter is a cosine similarity CS, a probability density function PDF, a probability mass function PMF, or a Euclidean distance.

Optionally, the first determining parameter is determined based on a parameter of the first AI encoder, first information, and first preprocessing, and the first preprocessing includes at least one of the following: translation, scaling, Fourier transform, compressive perception transform, truncation, AI model processing, and a corresponding processing parameter.

Optionally, the parameter of the first AI encoder is statistical information of a training data set of the first AI encoder, and the statistical information includes a mean and/or a distribution parameter of a mathematical distribution.

In a possible implementation, the first information is channel state information CSI or uplink data.

Optionally, the first information is CSI, and the method further includes: receiving a CSI-reference signal CSI-RS, where the first information is determined based on a measurement result of the CSI-RS.

In a possible implementation, the method further includes: sending second indication information to the network device, where the second indication information indicates the first encoder, or indicates that the first AI encoder is applicable to encoding the first information, or indicates that the first AI encoder is not applicable to encoding the first information; and receiving second configuration information, where the second configuration information is used to configure the first encoder, and the second configuration information is determined based on the second indication information.

Optionally, the second indication information is sent before the second information.

In this application, the first encoder used by the terminal can be obtained by requesting from the network device in real time, and the terminal may not need to store the first encoder in advance. This reduces storage pressure of the terminal.

In a possible implementation, the method further includes: receiving third configuration information, where the third configuration information is used to configure the first AI encoder and/or the second encoder.

Optionally, the third configuration information is received before the second information is sent.

According to a fourth aspect, embodiments of this application provide yet another information encoding control method, applied to a terminal. The method includes: receiving first configuration information, where the first configuration information is used to configure an AI decider, and the AI decider is configured to determine that a first AI encoder is applicable to encoding first information, and/or is configured to determine that the first AI encoder is not applicable to encoding the first information; and sending first indication information to a network device, where the first indication information indicates that a first encoder is used to encode the first information, the first encoder is determined based on the AI decider and the first information, and the first encoder is the first AI encoder or the first encoder is a second encoder different from the first AI encoder.

That the AI decider is configured to determine that a first AI encoder is applicable to encoding first information, and/or is configured to determine that the first AI encoder is not applicable to encoding the first information may be replaced with that the AI decider is configured to determine that a first AI codec is applicable to encoding and decoding first information, and/or is configured to determine that the first AI codec is not applicable to encoding and decoding the first information; or may be replaced with that the AI decider is configured to determine that a first AI decoder is applicable to decoding first information, and/or is configured to determine that the first AI decoder is not applicable to decoding the first information. The first AI encoder corresponds to the first AI decoder, and the first AI codec includes the first AI encoder and the first AI decoder.

Optionally, the second encoder is an encoder based on a conventional encoding solution such as a codebook, or another AI encoder with better generalization.

In this application, the first encoder used for encoding the first information is determined based on the AI decider, and the first encoder is the first AI encoder or the second encoder. It may be understood that the first encoder used for encoding the first information is determined to be applicable to encoding the first information. This avoids uncontrollable performance deterioration of a communication system and information distortion caused by encoding and decoding the first information by using an AI codec (or an AI encoder and an AI decoder) to which the first information is not applicable.

In a possible implementation, the first encoder is determined based on an output of the AI decider, and the output of the AI decider is obtained based on the first information and the AI decider.

Optionally, the output of the AI decider is obtained based on first input information and the AI decider, the first input information is obtained after the first information or second preprocessing of the first information, and the second preprocessing includes at least one of the following: translation, scaling, Fourier transform, compressive sensing transform, truncation, AI model processing, and a corresponding processing parameter.

Optionally, the output of the AI decider is obtained by processing first input information by using the AI decider.

Optionally, the output of the AI decider is an output obtained by using first input information as an input of the AI decider.

In a possible implementation, the method further includes: The first information is channel state information CSI or uplink data.

Optionally, the first information is CSI, and the method further includes: receiving a CSI-reference signal CSI-RS, where the first information is determined based on a measurement result of the CSI-RS.

In a possible implementation, the method further includes: sending second indication information to the network device, where the second indication information indicates the first encoder, or indicates that the first AI encoder is applicable to encoding the first information, or indicates that the first AI encoder is not applicable to encoding the first information; and receiving second configuration information, where the second configuration information is used to configure the first encoder, and the second configuration information is determined based on the second indication information.

Optionally, the second indication information is sent before the second information.

In this application, the first encoder used by the terminal can be obtained by requesting from the network device in real time, and the terminal may not need to store the first encoder in advance. This reduces storage pressure of the terminal.

In a possible implementation, the method further includes: receiving third configuration information, where the third configuration information is used to configure the first AI encoder and/or the second encoder.

Optionally, the third configuration information is received before the second information is sent.

According to a fifth aspect, embodiments of this application provide still yet another information encoding control method, applied to a terminal. The method includes: receiving first configuration information, where the first configuration information is used to configure N groups of parameters of N AI encoders or an AI decider, and the AI decider is configured to determine an AI encoder that is in the N AI encoders and to which first information is applicable, and/or is configured to determine that none of the N AI encoders is applicable to encoding the first information; sending first request information to a network device, where the first request information indicates a first AI encoder in the N AI encoders, and the first request information is determined based on the first configuration information and the first information; and sending first indication information to the network device, where the first indication information indicates a second encoder, and the second encoder is different from the N AI encoders.

Optionally, the second encoder is an encoder based on a conventional encoding solution such as a codebook, or another AI encoder with better generalization.

Optionally, the method further includes: receiving second configuration information sent by the network device, where the second configuration information is used to configure the first AI encoder, and the second configuration information is determined based on the first request information.

In this application, although there is the first AI encoder applicable to the first information, the first AI encoder is not sent to the terminal. In this case, the terminal may perform encoding by using the second encoder. This reduces a transmission delay and ensures that a process of feeding back information encoding is not interrupted.

In a possible implementation, the method further includes: sending second information, where the second information is determined based on the first information and the second encoder.

In a possible implementation, the first request information is determined based on a relationship between a first determining parameter and a first determining threshold, the first determining parameter is determined based on the N groups of parameters and the first information, and the first determining parameter is a cosine similarity CS, a probability density function PDF, a probability mass function PMF, or a Euclidean distance.

In a possible implementation, the first request information is determined based on an output of the AI decider, and the output of the AI decider is obtained based on the first information and the AI decider.

In a possible implementation, the method may further include: sending fourth information and third indication information, where the third indication information indicates the first AI encoder, and the fourth information is determined based on the first AI encoder and third information.

Optionally, the third information is channel state information CSI or uplink data.

In this application, although the terminal uses the second encoder, the terminal can send information to the network device, to request to configure the first AI encoder, so that the fourth information to which the first AI encoder is applicable is directly encoded subsequently, without requesting again. This reduces transmission overheads and the transmission delay.

In a possible implementation, the first information is channel state information CSI or uplink data.

According to a sixth aspect, embodiments of this application provide a further information encoding control method, applied to a terminal. The method includes: receiving first configuration information, where the first configuration information is used to configure N groups of parameters of N AI encoders or an AI decider, and the AI decider is configured to determine an AI encoder that is in the N AI encoders and to which first information is applicable, and/or is configured to determine that none of the N AI encoders is applicable to encoding the first information; sending fourth indication information to a network device, where the fourth indication information indicates whether the first information is applicable to a first determining result and/or a first determining parameter of the N AI encoders, and the fourth indication information is determined based on the first configuration information and the first information; and receiving fifth indication information, where the fifth indication information indicates that the first encoder is used for encoding the first information, the fifth indication information is determined based on the fourth indication information, and the first encoder is an encoder in the N AI encoders, or the first encoder is a second encoder different from the N AI encoders.

Optionally, the second encoder is an encoder based on a conventional encoding solution such as a codebook, or another AI encoder with better generalization.

In this application, the first encoder used for encoding the first information is determined based on the first configuration information, and the first encoder is one of the N AI encoders or the second encoder different from the N AI encoders. It may be understood that the first encoder used for encoding the first information is determined to be applicable to encoding the first information. This avoids uncontrollable performance deterioration of a communication system and information distortion caused by encoding and decoding the first information by using an AI codec (or an AI encoder and an AI decoder) to which the first information is not applicable.

In a possible implementation, the first determining result is used to indicate that the first information is applicable to the first AI encoder in the N AI encoders, or is used to indicate that none of the N AI encoders is applicable to the first information.

In a possible implementation, the first determining parameter is determined based on the N groups of parameters and the first information, and the first determining parameter is a cosine similarity CS, a probability density function PDF, a probability mass function PMF, or a Euclidean distance.

In a possible implementation, the first determining parameter is an output of the AI decider, and the output of the AI decider is obtained based on the first information and the AI decider.

In a possible implementation, the first information is channel state information CSI or uplink data.

According to a seventh aspect, embodiments of this application provide a still further information encoding control method, applied to a terminal. The method includes: receiving first configuration information, where the first configuration information is used to configure N groups of parameters of N AI encoders or an AI decider, and the AI decider is configured to determine an AI encoder that is in the N AI encoders and to which first information is applicable, and/or is configured to determine that none of the N AI encoders is applicable to encoding the first information; and sending first information to the network device, where the first information is not encoded or is encoded in a high-fidelity mode, the first information is used as a training data set of a first AI encoder to train the first AI encoder, and that the first information is used as a training data set of a first AI encoder is determined based on the first configuration information and the first information.

In this application, the terminal can perform filtering on to-be-transmitted information based on the first configuration information, to send, to the network device, data of high value for training an AI codec. This prevents the terminal from sending, to the network device, data of low value for training the AI codec, and avoids waste of uplink bandwidth due to poor performance of the AI codec caused by unbalanced training data.

In a possible implementation, that the first information is used as a training data set of a first AI encoder is determined based on a relationship between a first determining parameter and a first determining threshold, the first determining parameter is determined based on the N groups of parameters and the first information, and the first determining parameter is a cosine similarity CS, a probability density function PDF, a probability mass function PMF, or a Euclidean distance.

In a possible implementation, that the first information is used as a training data set of a first AI encoder is determined based on an output of the AI decider, and the output of the AI decider is obtained based on the first information and the AI decider.

In a possible implementation, the first information is channel state information CSI or uplink data.

According to an eighth aspect, embodiments of this application provide a yet further information encoding control method, applied to a network device. The method includes: sending first configuration information to a terminal; where the first configuration information is used to configure N groups of parameters of N AI encoders or an AI decider, and the AI decider is configured to determine an AI encoder that is in the N AI encoders and to which first information is applicable, and/or is configured to determine that none of the N AI encoders is applicable to encoding the first information; and receiving first indication information and second information, where the second information is determined by the terminal based on the first information and a first encoder, the first indication information indicates that the first encoder is used for encoding the first information, the first encoder is determined based on the first configuration information and the first information, and the first encoder is an encoder in the N AI encoders, or the first encoder is a second encoder different from the N AI encoders.

In a possible implementation, the method further includes: decoding the second information by using a first decoder corresponding to the first encoder.

In a possible implementation, the first encoder is determined based on a relationship between a first determining parameter and a first determining threshold, the first determining parameter is determined based on the N groups of parameters and the first information, and the first determining parameter is a cosine similarity CS, a probability density function PDF, a probability mass function PMF, or a Euclidean distance.

In a possible implementation, the first encoder is determined based on an output of the AI decider, and the output of the AI decider is obtained based on the first information and the AI decider.

In a possible implementation, the first information is channel state information CSI or uplink data.

According to a ninth aspect, embodiments of this application provide a still yet further information encoding control method, applied to a network device. The method includes: sending first configuration information to a terminal, where the first configuration information is used to configure N groups of parameters of N AI encoders or an AI decider, and the AI decider is configured to determine an AI encoder that is in the N AI encoders and to which first information is applicable, and/or is configured to determine that none of the N AI encoders is applicable to encoding the first information; receiving first request information, where the first request information indicates a first AI encoder in the N AI encoders, the first request information is determined based on the first configuration information and the first information; and receiving first indication information and second information, where the first indication information indicates that a second encoder is used for encoding the first information, the second encoder is different from the N AI encoders, and the second information is determined based on the first information and the second encoder.

Optionally, the second encoder is an encoder based on a conventional encoding solution such as a codebook, or another AI encoder with better generalization.

Optionally, the method further includes: sending second configuration information, where the second configuration information is used to configure the first AI encoder, and the second configuration information is determined based on the first request information.

In a possible implementation, the method further includes: decoding the second information by using a second decoder corresponding to the second encoder.

In a possible implementation, the first request information is determined based on a relationship between a first determining parameter and a first determining threshold, the first determining parameter is determined based on the N groups of parameters and the first information, and the first determining parameter is a cosine similarity CS, a probability density function PDF, a probability mass function PMF, or a Euclidean distance.

In a possible implementation, the first request information is determined based on an output of the AI decider, and the output of the AI decider is obtained based on the first information and the AI decider.

In a possible implementation, the method may further include: receiving fourth information and third indication information, where the third indication information indicates the first AI encoder, and the fourth information is determined based on the first AI encoder and third information.

Optionally, the fourth information is channel state information CSI or uplink data.

In a possible implementation, the first information is channel state information CSI or uplink data.

According to a tenth aspect, embodiments of this application provide an even yet another information encoding control method, applied to a network device. The method includes: sending first configuration information to a terminal, where the first configuration information is used to configure N groups of parameters of N AI encoders or an AI decider, and the AI decider is configured to determine an AI encoder that is in the N AI encoders and to which first information is applicable, and/or is configured to determine that none of the N AI encoders is applicable to encoding the first information; receiving fourth indication information, where the fourth indication information indicates whether the first information is applicable to a first determining result and/or a first determining parameter of the N AI encoders, and the fourth indication information is determined based on the first configuration information and the first information; and sending fifth indication information, where the fifth indication information indicates that the first encoder is used for encoding the first information, the fifth indication information is determined based on the fourth indication information, and the first encoder is an encoder in the N AI encoders, or the first encoder is a second encoder different from the N AI encoders.

Optionally, the second encoder is an encoder based on a conventional encoding solution such as a codebook, or another AI encoder with better generalization.

In a possible implementation, the first determining result is used to indicate that the first information is applicable to a first AI encoder in the N AI encoders, or is used to indicate that none of the N AI encoders is applicable to the first information.

In a possible implementation, the first determining parameter is determined based on the N groups of parameters and the first information, and the first determining parameter is a cosine similarity CS, a probability density function PDF, a probability mass function PMF, or a Euclidean distance.

In a possible implementation, the first determining parameter is an output of the AI decider, and the output of the AI decider is obtained based on the first information and the AI decider.

In a possible implementation, the first information is channel state information CSI or uplink data.

According to an eleventh aspect, embodiments of this application provide an even yet another information encoding control method, applied to a network device. The method includes: sending first configuration information to a terminal, where the first configuration information is used to configure N groups of parameters of N AI encoders or an AI decider, and the AI decider is configured to determine an AI encoder that is in the N AI encoders and to which first information is applicable, and/or is configured to determine that none of the N AI encoders is applicable to encoding the first information; and receiving the first information, where the first information is not encoded or is encoded in a high-fidelity mode, the first information is used as a training data set of a first AI encoder to train the first AI encoder, and that the first information is used as a training data set of a first AI encoder is determined based on the first configuration information and the first information.

In a possible implementation, that the first information is used as a training data set of a first AI encoder is determined based on a relationship between a first determining parameter and a first determining threshold, the first determining parameter is determined based on the N groups of parameters and the first information, and the first determining parameter is a cosine similarity CS, a probability density function PDF, a probability mass function PMF, or a Euclidean distance.

In a possible implementation, that the first information is used as a training data set of a first AI encoder is determined based on an output of the AI decider, and the output of the AI decider is obtained based on the first information and the AI decider.

In a possible implementation, the first information is channel state information CSI or uplink data.

According to a twelfth aspect, embodiments of this application provide a terminal, including a transceiver, a processor, and a memory. The memory is configured to store computer program code, the computer program code includes computer instructions, and the processor invokes the computer instructions, so that the foregoing user equipment performs the information encoding control method provided in any one of the first aspect to the seventh aspect and implementations of the first aspect to the seventh aspect in embodiments of this application.

According to a thirteenth aspect, embodiments of this application provide a network device, including a transceiver, a processor, and a memory. The memory is configured to store computer program code, the computer program code includes computer instructions, and the processor invokes the computer instructions, so that the user equipment performs the information encoding control method provided in any one of the eighth aspect and the eleventh aspect and implementations of the eighth aspect and the eleventh aspect in embodiments of this application.

According to a fourteenth aspect, embodiments of this application provide another terminal, configured to perform the method performed by the terminal in any embodiment of this application.

According to a fifteenth aspect, embodiments of this application provide a network device, configured to perform the method performed by the network device in any embodiment of this application.

According to a sixteenth aspect, embodiments of this application provide a computer storage medium. The computer storage medium stores a computer program. When being executed by an electronic device, the computer program is configured to perform the information encoding control method provided in any one of the first aspect to the eleventh aspect and implementations of the first aspect to the eleventh aspect in embodiments of this application.

According to a seventeenth aspect, embodiments of this application provide a computer program product. When the computer program product runs on an electronic device, the electronic device is enabled to perform the information encoding control method provided in any one of the first aspect to the eleventh aspect and implementations of the first aspect to the eleventh aspect in embodiments of this application.

According to an eighteenth aspect, embodiments of this application provide an electronic device. The electronic device includes a component for performing the method or apparatus in any embodiment of this application. The electronic device is, for example, a chip.

## BRIEF DESCRIPTION OF DRAWINGS

The following describes the accompanying drawings used in embodiments of this application.

FIG. 1 is a schematic diagram of an architecture of a communication system according to an embodiment of this application;
FIG. 2 is a schematic diagram of a scenario of information encoding and decoding according to an embodiment of this application;
FIG. 3 is a schematic diagram of a structure of a terminal 100 according to an embodiment of this application;
FIG. 4 is a schematic diagram of a structure of a network device 200 according to an embodiment of this application;
FIG. 5 to FIG. 10 are schematic flowcharts of some information encoding control methods according to an embodiment of this application;
FIG. 11 is a schematic flowchart of a filtering method according to an embodiment of this application;
FIG. 12 and FIG. 13 are schematic diagrams of generation processes of some artificial intelligence AI deciders according to an embodiment of this application; and
FIG. 14 is a schematic diagram of a generation process of an AI codec according to an embodiment of this application.

## DESCRIPTION OF EMBODIMENTS

The technical solutions according to embodiments of this application are clearly and completely described in the following with reference to the accompanying drawings. Terms used in implementations of embodiments of this application are merely used to explain specific embodiments of this application, and are not intended to limit this application.

Embodiments of this application provide an information encoding control method, applied to a communication system including a network device and a terminal. The network device may send first configuration information to the terminal, and the terminal may determine, based on the first configuration information, whether to-be-transmitted information is applicable to an artificial intelligence (artificial intelligence, AI) model for information encoding (which may also be understood as an AI technology-based encoder, AI encoder for short). If the to-be-transmitted information is applicable to the AI encoder, the terminal may encode the to-be-transmitted information by using the AI encoder; or if the to-be-transmitted information is not applicable to the AI encoder, the terminal may encode the to-be-transmitted information by using a standby encoder. This can quickly and efficiently select an appropriate information encoding solution, avoid distortion after the to-be-transmitted information is encoded and decoded, avoid impact on performance of the communication system, and improve transmission quality.

It should be noted that one AI encoder may correspond to one AI model for information decoding (which may also be understood as an AI technology-based decoder, AI decoder for short), an AI encoder and a corresponding AI decoder may be referred to as an AI codec for short (which may also be understood as an AI-based codec), and different AI codecs have different structures or the same structures but different model parameters (coefficients). Different AI codecs correspond to different identifiers. AI encoders in different AI codecs may be the same but AI decoders are different, or AI decoders in different AI codecs may be the same but AI encoders may be different. The information encoded by using the AI encoder needs to be decoded by using a corresponding AI decoder in a same group, and cannot be decoded by using another decoder (or decoded information deviates greatly from the original to-be-transmitted information). The AI encoder and the corresponding AI decoder are usually trained as an autoencoder (autoencoder), that is, during training, both an input of the AI encoder and an output of the AI decoder are set as the to-be-encoded information (which may be understood as a training data set of the AI encoder, the AI decoder, or the AI codec). A parameter (coefficient) of the AI model (including the AI encoder and/or the AI decoder) is obtained by using error back propagation, so that during inference, information obtained after AI encoding and AI decoding are performed on the to-be-encoded information is consistent as much as possible with the to-be-encoded information.

Optionally, that the to-be-encoded information is applicable to the AI encoder represents that the to-be-encoded information is applicable to the AI decoder corresponding to the AI encoder, and also be understood that the to-be-encoded information is applicable to a corresponding AI codec (including the foregoing AI encoder and the corresponding AI decoder). Therefore, that the terminal determines, based on the first configuration information, whether to-be-transmitted information is applicable to an AI encoder may be understood as that the terminal determines, based on the first configuration information, whether the to-be-transmitted information is applicable to the AI encoder and the corresponding AI decoder (namely, the AI codec).

Correspondingly, the standby encoder may also correspond to a decoder (a standby decoder for short). Information encoded by using the standby encoder also needs to be decoded by using the corresponding standby decoder, and cannot be decoded by using another decoder. A decoding solution of the standby decoder depends on an encoding solution of the corresponding standby encoder. For example, if the standby encoder is an encoder based on a conventional encoding solution such as a codebook, the corresponding standby decoder is a decoder based on a conventional decoding solution such as a codebook; or if the standby encoder is another AI encoder with better generalization, the corresponding standby decoder is another AI decoder with better generalization.

Optionally, the terminal may feed back the encoded information to the network device, and send, to the network device, a notification indicating the encoder used by the terminal. The network device may determine the corresponding decoder based on the notification, and perform decoding by using the decoder to obtain the information reported by the terminal. When the encoder used by the terminal is an AI encoder, the decoder used by the network device is an AI decoder corresponding to the AI encoder. When the encoder used by the terminal is a standby encoder, the decoder used by the network device is a standby decoder corresponding to the standby encoder.

In this application, the to-be-transmitted information is information sent by the terminal to the network device, and may be measurement information such as channel state information (channel state information, CSI), or status information. This is not limited thereto. The information may also be service data, for example, audio data, video data, or text data.

Optionally, the AI encoder or the standby encoder used by the terminal may be sent by the network device to the terminal. Optionally, the AI encoder or the standby encoder used by the terminal may be pre-configured through negotiation between the terminal and the network device.

In this application, the communication system may be a wireless communication system, for example, but not limited to a global system for mobile communications (global system for mobile communications, GSM), code division multiple access (code division multiple access, CDMA), wideband code division multiple access (wideband code division multiple access, WCDMA), time division synchronous code division multiple access (time division synchronous code division multiple access, TD-SCDMA), long term evolution (long term evolution, LTE), new radio (new radio, NR) access, or another future network system.

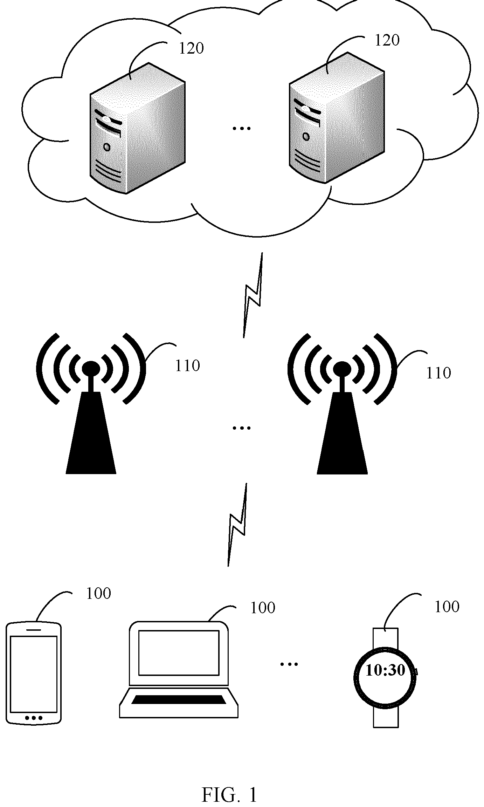

In this application, the network device may be a device configured to send or receive information. Optionally, the network device is an access network device. Optionally, the network device is a core network device. The network device is, for example, but not limited to a base station, user equipment (user equipment, UE), a wireless access point (access point, AP), a transmission reception point (transmission and receiver point, TRP), a relay device, or another network device having a function of a base station. A base station is a device deployed in a radio access network (radio access network, RAN) to provide a wireless communication function. The base station may have different names in different wireless access systems, for example, but not limited to a base transceiver station (base transceiver station, BTS) in GSM or CDMA, a NodeB (NodeB, NB) in WCDMA, or an evolved NodeB (evolved NodeB, eNodeB) in LTE; or may be a next-generation base station (gNodeB, gNB) in NR, or a base station in another future network system. For example, the network device may be a base station 110 or a core network 120 shown in FIG. 1.

In this application, the terminal may be a device with a wireless communication function. Optionally, the terminal is UE. In some scenarios, the terminal may also be referred to as a mobile station, an access terminal, a user agent, or the like. For example, the terminal is a terminal in a form of a handheld device, a wearable device, a computing device, a portable device, or a vehicle-mounted device. For example, the terminal is specifically a device such as a cellular phone, a smartphone, smart glasses, a laptop computer, a personal digital assistant, or a cordless phone. For example, the terminal may be a terminal 100 shown in FIG. 1.

FIG. 1 is a schematic diagram of an architecture of a communication system according to an embodiment of this application.

As shown in FIG. 1, the communication system may include terminals 100, base stations 110, and core networks 120. The core network 120 may be connected to the at least one base station 110, the base station 110 may provide a wireless communication service for the at least one terminal 100, and the terminal 100 may be connected to the at least one base station 110 through an air interface. The core network 120 is a key control node in the communication system, and is mainly responsible for a signaling processing function, for example, but not limited to implementing functions such as access control, mobility management, and session management. The at least one base station 110 may constitute one RAN node. In NR, the core network 120 may be referred to as a 5G core (5G Core, 5GC) network 120, and the base station 110 may be referred to as a gNB 110. An NR-RAN node may include the at least one gNB 110 connected to the 5GC 120 through an NG interface, and at least one gNB 110 in the NR-RAN node may be connected and communicate with each other through an Xn-C interface. The terminal 100 may be connected to the gNB 110 through a Uu interface.

The core network 120 may send downlink information to the terminal 100 via the base station 110, or the terminal 100 may send uplink information to the core network 120 via the connected base station 110. When being within a coverage area of the base station 110, the terminal 100 can be connected to the base station 110 only after an operation such as random access is performed. After the connection, the terminal 100 can exchange information with the base station 110, and exchange information with the core network 120 via the base station 110.

It should be noted that forms and quantities of the terminals 100, the base stations 110, and the core networks 120 shown in FIG. 1 are merely examples. This is not limited in this embodiment of this application.

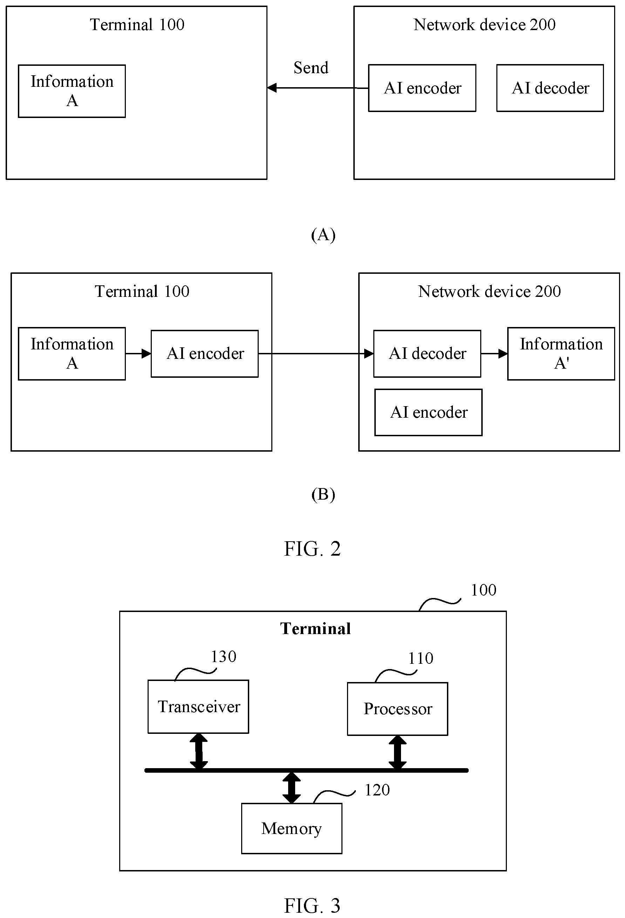

FIG. 2 is a schematic diagram of an example of a scenario of information encoding and decoding. The scenario shown in FIG. 2 includes a terminal 100 and a network device 200. The terminal 100 and the network device 200 may be connected and communicate with each other.

As shown in (A) in FIG. 2, an AI encoder and a corresponding AI decoder may be deployed in the network device 200. The network device 200 may send the AI encoder to the terminal 100, so that the terminal 100 subsequently encodes to-be-transmitted information (namely, information A) by using the AI encoder. As shown in (B) in FIG. 2, the terminal 100 may determine whether the information A is applicable to the AI encoder sent by the network device 200. When the information A is applicable, the terminal 100 may encode the information A by using the AI encoder, and send the encoded information to the network device 200. Then, the network device 200 may decode the encoded information by using the AI decoder, to obtain restored information (namely, information A').

The following describes, by using examples, the terminal and the network device provided in embodiments of this application.

FIG. 3 is a schematic diagram of a structure of a terminal 100. The terminal 100 may be the terminal 100 shown in FIG. 1, or may be the terminal 100 shown in FIG. 2. The terminal 100 may include a processor 110, a memory 120, and a transceiver 130. The processor 110, the memory 120, and the transceiver 130 are connected to each other through a bus.

The processor 110 may be one or more central processing units (central processing units, CPUs). When the processor 110 is one CPU, the CPU may be a single-core CPU, or may be a multi-core CPU. In some embodiments, the processor 110 may include a plurality of processing units, for example, an application processor (application processor, AP), a modem (modem), or the like. Different processing units may be independent components, or may be integrated into one or more processors. The memory 120 may include but is not limited to a random access memory (random access memory, RAM), a read-only memory (read-only memory, ROM), an erasable programmable read-only memory (erasable programmable read-only memory, EPROM), or a compact disc read-only memory (compact disc read-only memory, CD-ROM). The memory 120 is configured to store a related computer program and information. Optionally, the memory 120 is configured to store an AI encoder sent by a network device. Optionally, the memory 120 is configured to store an AI model (an AI decider for short) that is sent by a network device and that is used to determine whether there is an AI encoder to which to-be-transmitted information is applicable. The transceiver 130 is configured to receive and send information. In some embodiments, the transceiver 130 may include a wireless transceiver and a mobile transceiver.

In some embodiments, the terminal 100 may implement mobile communication technologies such as GSM, CDMA, WCDMA, SCDMA, a UMTS, LTE, and NR by using a modem processor and a mobile transceiver. The terminal 100 may communicate with the network device by using the modem processor and the mobile transceiver, for example, transmit measurement information such as CSI, status information, and the AI encoder.

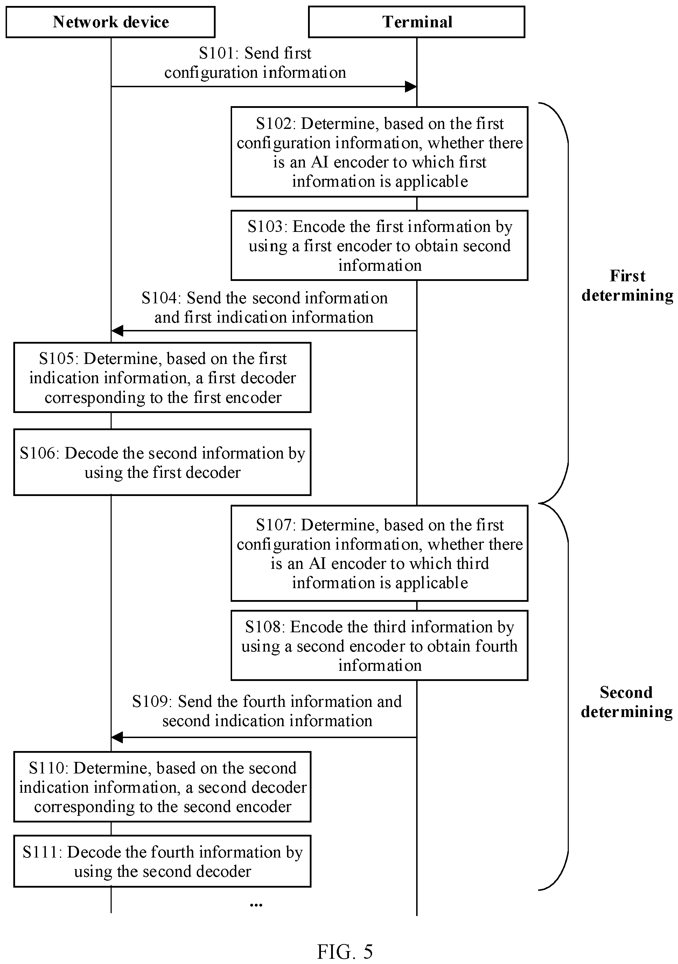

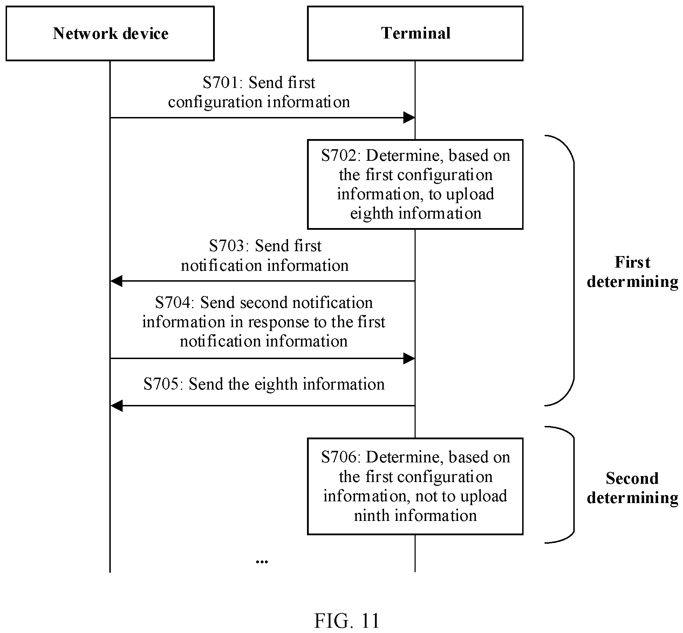

The processor 110 in the terminal 100 is configured to read computer program code stored in the memory 120, and perform steps performed by terminals in information encoding control methods shown in FIG. 5 to FIG. 10 and a filtering method shown in FIG. 11.

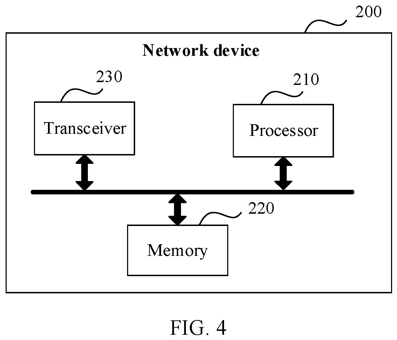

FIG. 4 is a schematic diagram of a structure of a network device 200. The network device 200 may be the base station 110 or the core network 120 shown in FIG. 1, or may be the network device 200 shown in FIG. 2. The network device 200 may include a processor 210, a memory 220, and a transceiver 230. The processor 210, the memory 220, and the transceiver 230 are connected to each other through a bus.

The processor 210 may be one or more CPUs. When the processor 210 is one CPU, the CPU may be a single-core CPU, or may be a multi-core CPU. In some embodiments, the processor 210 may include a plurality of processing units. Different processing units may be independent components, or may be integrated into one or more processors. Optionally, the processor 210 may generate an AI codec through training. Optionally, the processor 210 may generate an AI decider through training. The memory 220 may include but is not limited to a RAM, a ROM, an EPROM, or a CD-ROM. The memory 220 is configured to store a related computer program and information. Optionally, the memory 220 is configured to store an obtained AI codec. Optionally, the memory 220 is configured to store an obtained AI decider. The transceiver 230 is configured to receive and send information.

In some embodiments, the network device 200 may implement mobile communication technologies such as GSM, CDMA, WCDMA, SCDMA, a UMTS, LTE, and NR by using the processor 210 and the transceiver 230. The network device 200 may communicate with a terminal by using the processor 210 and the transceiver 230, for example, transmit measurement information such as CSI, status information, and an AI encoder.

The processor 210 in the network device 200 is configured to read computer program code stored in the memory 220, and perform steps performed by a network device in information encoding control methods shown in FIG. 5 to FIG. 10 and a filtering method shown in FIG. 11.

The following describes information encoding control method provided in embodiments of this application. The method is applied to the communication system shown in FIG. 1, or is applied to the scenario shown in FIG. 2. A terminal in the method may be the terminal 100 shown in FIG. 3. A network device in the method may be the network device 200 shown in FIG. 4.

FIG. 5 is a schematic flowchart of an information encoding control method according to an embodiment of this application. The method may include but is not limited to the following steps.

S101: A network device sends first configuration information to a terminal.

In some embodiments, before S101, the method may include: connecting the network device to the terminal. For a connection manner, refer to descriptions in FIG. 1 to FIG. 4. For example, it is assumed that the network device is a base station, and the terminal enters a coverage area of the base station to initiate random access to the base station. After the random access succeeds, the terminal is connected to the base station, and may perform communication.

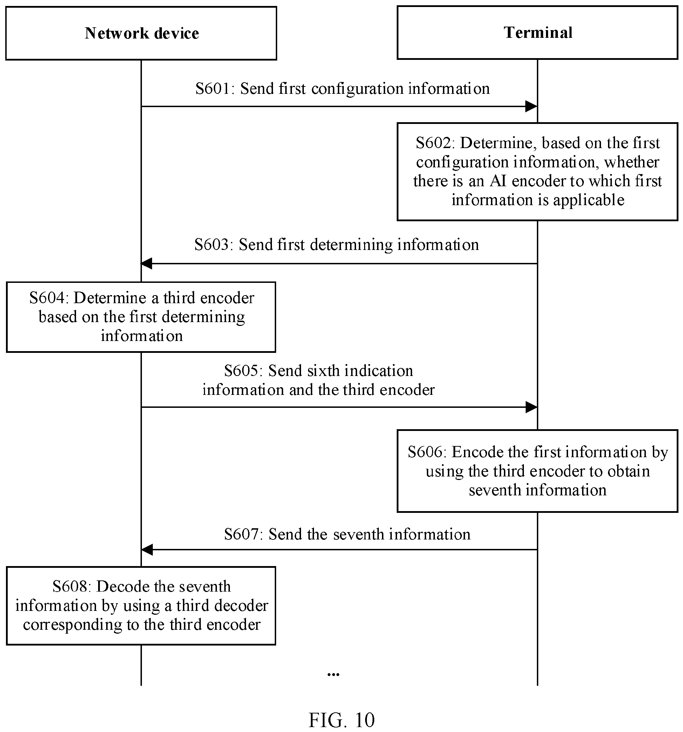

In some embodiments, before S101, the method may include: The network device determines, through negotiation with the terminal, to enable an information encoding feedback mechanism based on an AI encoder. Subsequently, the network device may send an AI encoder to the terminal, and the terminal may perform encoding by using the AI encoder at a negotiated moment. The negotiation moment is, for example, but not limited to, a moment (for example, after S102) at which the terminal determines, based on the first configuration information, that there is an AI encoder to which to-be-transmitted information is applicable, or a moment (for example, after sixth indication information shown in FIG. 10 is received) at which that the terminal receives information that is sent by the network device and that indicates to use the encoder.

Specifically, S101 is optional. Optionally, the first configuration information may include information about N AI codecs, or may be understood as information about N AI encoders, or may be understood as information about N AI decoders. The N AI encoders respectively correspond to the N AI decoders, and the N AI codecs may include the N AI encoders and the N AI decoders. Optionally, the first configuration information may include content of the following three cases.

Case 1: The first configuration information may include statistical information of training data sets of the N AI codecs (which may also be understood as the N AI encoders) obtained by the network device, where N is a positive integer. Optionally, the first configuration information may include N groups of second configuration information, the N groups of second configuration information respectively correspond to the N AI codecs, and each group of second configuration information may include statistical information of a training data set of a corresponding AI codec. The statistical information may include but is not limited to a mean and/or a distribution parameter of a mathematical distribution, where a distribution parameter of any mathematical distribution may be determined based on a characteristic of the mathematical distribution. For example, statistical information for an AI codec includes means and variances of two normal distributions, where the means and variances of the two normal distributions are different; or statistical information for an AI codec includes a mean and variance of a normal distribution, and a mean and $\lambda$ of a Poisson distribution.

In some embodiments, the statistical information may be in a plurality of different dimensions. For example, it is assumed that a dimension of a training data set is $[L, K_1, K_2, ..., K_z]$, where $L, K_1, K_2, ..., K_z$ each are a positive integer, $K_1, K_2, ..., K_z$ is a feature dimension of the training data set, and L is a statistical dimension of the training data set. In this case, a mean and a distribution parameter of a mathematical distribution of the training data set may be a dimension along $K_1, K_2, ..., K_z$, or may be a combination dimension of $K_1 \times K_2 \times ... \times K_z$, and this is not limited thereto; and may be another permutation and combination dimension. This is not limited in this application.

Case 2 is similar to Case 1, and a difference lies in that first preprocessing is performed on statistical information in the first configuration information, where the first preprocessing may include at least one of the following: translation, scaling, Fourier transform, compressive sensing transform (namely, multiplication by a compressive sensing measurement matrix), truncation, and AI model processing. Optionally, the first preprocessing may further include a corresponding processing parameter, for example, a translation direction and value.

The AI model processing may be performed by using an AI model or a shallow part of the AI model, for example, performing feature extraction, to implement dimension reduction. It should be noted that the AI model herein may be different from an AI model of the AI encoder and an AI model of the AI decoder. For example, it is assumed that to-be-processed information is a CSI matrix H whose dimension is $R \times W$. The CSI matrix H may be processed (that is, compressive sensing encoding is performed) at a fully connected linear layer of an AI model, and the processing specifically includes multiplying the CSI matrix H by a measurement matrix U whose dimension is $E \times R$, where E may be far less than R. A processed matrix is $O = U \times H$, where a dimension of a matrix O is $E \times W$. It is assumed that a decoding algorithm corresponding to compressive sensing encoding is Learned AMP (LAMP), a CSI matrix $H' = LAMP(U \times H)$ is obtained after decoding. The matrix U may be obtained through training as a layer of neural network, that is, the measurement matrix U is obtained through training by using the known CSI matrix H based on the foregoing formula for obtaining the CSI matrix after decoding. Optionally, the measurement matrix in the compressive sensing transform may be randomly generated, for example, randomly generated by using Gaussian distribution.

This is not limited thereto, and there may be another type of preprocessing. Specific content of preprocessing is not limited in this application.

In some embodiments, the first configuration information may further include first preprocessing information, so that the terminal can determine first preprocessing content based on the first configuration information. Optionally, specifically, each group of second configuration information includes corresponding first preprocessing information. In some other embodiments, before S101, the method may further include: The terminal receives first preprocessing information sent by the network device. In some other embodiments, before S101, the method may further include: The network device determines, through negotiation with the terminal, first preprocessing content, that is, the first preprocessing is predefined. Content of first preprocessing performed on statistical information of training data sets of different AI encoders may be different. For example, first preprocessing indicated by different groups of second configuration information may be different.

Optionally, when determining whether the to-be-transmitted information is applicable to a to-be-applied AI encoder (namely, any AI encoder in the N AI codecs), the terminal needs to perform first preprocessing on the to-be-transmitted information, and then performs a determining process based on information after the first preprocessing, as shown in S102. Correspondingly, when encoding the to-be-transmitted information by using the AI encoder (corresponding to the first preprocessing herein), the terminal needs to first perform the first preprocessing on the to-be-transmitted information, and then encode, by using the AI encoder, the information obtained after the first preprocessing, as shown in S103.

For example, it is assumed that the first preprocessing indicated by the first configuration information includes Fourier transform, truncation, and compressive sensing transform. When performing the determining process and encoding by using the AI encoder, the terminal needs to first perform Fourier transformation, truncation and discarding, and multiplication by the compressive sensing measurement matrix on the to-be-transmitted information.

In Case 1 and Case 2, in some embodiments, the first configuration information may further include an indication of a type of the statistical information. Optionally, specifically, each group of second configuration information includes an indication of a type of statistical information, and types of statistical information included in different groups of second configuration information may be different. In some other embodiments, before S101, the method may further include: The network device determines, through negotiation with the terminal, a type of the statistical information, that is, the type of the statistical information is predefined.

In Case 1 and Case 2, in some embodiments, the first configuration information may further include a group of determining thresholds, and optionally, may further include a determining method for determining, based on the group of determining thresholds, whether the to-be-transmitted information is applicable to the to-be-applied AI encoder. In some other embodiments, before S101, the method may further include: The network device determines, through negotiation with the terminal, a group of determining thresholds, and optionally, the foregoing determining method, that is, the determining threshold is predefined, and optionally, the determining method is predefined. The group of determining thresholds may include at least one determining threshold. In some other embodiments, before S101, the method may further include: The terminal receives a determining threshold and/or a determining method sent by the network device. Optionally, determining thresholds determined by the network device for different terminals may be different.

Case 3: The first configuration information may include an AI decider, namely an AI model for determining whether the to-be-transmitted information is applicable to the to-be-applied AI encoder. Optionally, an input of the AI decider is the to-be-transmitted information corresponding to the terminal. Optionally, an input of the AI decider is obtained after second preprocessing is performed on the to-be-transmitted information. There is at least one output port of the AI decider, for example, N output ports, which respectively correspond to the foregoing N AI codecs (which may also be understood as corresponding to the N AI encoders).

For example, when N is equal to 1, an output of the AI decider represents whether the to-be-transmitted information is applicable to the AI encoder.

For example, when N is greater than 1, N outputs of the AI decider may represent a case in which the to-be-transmitted information is applicable to the N AI encoders. An output of any output port of the AI decider may represent a probability that the to-be-transmitted information is applicable to an AI encoder corresponding to the output port, where a higher probability indicates that the to-be-transmitted information is more applicable to the AI encoder, that is, there is better expected effect of applying an AI codec corresponding to the output port to perform information encoding and decoding on the to-be-transmitted information.

In some embodiments, the first configuration information may further include indication information of the output of the AI decider. The indication information may include content represented by the output of the AI decider, for example, representing whether the to-be-transmitted information is applicable to the to-be-applied AI encoder, or representing the probability that the to-be-transmitted information is applicable to the to-be-applied AI encoder. Optionally, the indication information may further include an output threshold of the AI decider (output threshold for short) and a determining method for determining, based on the output threshold and the output of the AI decider, whether the to-be-transmitted information is applicable to the to-be-applied AI encoder. In some other embodiments, before S101, the method may further include: The network device determines, through negotiation with the terminal, indication information of the output of the AI decider, that is, the indication information is predefined. In some other embodiments, before S101, the method may further include: The terminal receives indication information, of the output of the AI decider, sent by the network device.

For example, when N is equal to 1, the output of the AI decider is 0 or 1. When the output is 1, it indicates that the to-be-transmitted information is applicable to the AI encoder; or when the output is 0, it indicates that the to-be-transmitted information is not applicable to the AI encoder. Alternatively, a value range of the output of the AI decider is [0, 1]. A larger output indicates that the first information is more applicable to the AI encoder, that is, there is better expected effect of applying an AI codec corresponding to the output port to perform information encoding and decoding on the to-be-transmitted information. When the output is greater than the output threshold, the terminal may determine that the to-be-transmitted information is applicable to the AI encoder; otherwise, the terminal may determine that the to-be-transmitted information is not applicable to the AI encoder.

For example, when N is greater than 1, N output ports of the AI decider separately output $I_1$, $I_2$, ... , $I_N$, where $I_1 + I_2 + ... + I_N = 1$. When $I_i > I_t$, it represents that the to-be-transmitted information is applicable to an AI encoder corresponding to an $i^{th}$ output port, where a value range of i is [1, N], and $I_t$ is an output threshold of the AI decider. When $I_i > I_t$ and $I_i$ is greater than outputs of other (N-1) output ports, it represents that the to-be-transmitted information is most applicable to the AI encoder corresponding to the $i^{th}$ output port, that is, there is best expected effect of applying an AI codec corresponding to the $i^{th}$ output port to perform information encoding and decoding on the to-be-transmitted information.

For an example of an output of another AI decider, refer to the description of the output of the AI decider in S102. Details are not described temporarily.

In some embodiments, the first configuration information may further include second preprocessing information, so that the terminal can determine second preprocessing content based on the first configuration information. In some other embodiments, before S101, the method may further include: The network device determines, through negotiation with the terminal, second preprocessing content, that is, the second preprocessing is predefined. In some other embodiments, before S101, the method may further include: The terminal receives second preprocessing information sent by the network device. The first preprocessing and the second preprocessing may be the same or different. For an example of the second preprocessing content, refer to the foregoing example of the first preprocessing.

In some embodiments, in Case 3, the first configuration information may alternatively include first preprocessing information, or the first preprocessing is predefined, so that when encoding the to-be-transmitted information by using the AI encoder, the terminal first performs the first preprocessing on the to-be-transmitted information, and then encodes, by using the AI encoder, information after the first preprocessing. For details, refer to S103. In addition, if the first configuration information includes second preprocessing information or the second preprocessing is predefined, when determining whether the to-be-transmitted information is applicable to the to-be-applied AI encoder, the terminal needs to first perform second preprocessing on the to-be-transmitted information, and then perform a determining process based on information after the second processing, specifically, as shown in S102.

In the three cases, in some embodiments, the first configuration information may further include performance requirements of the N AI encoders, for example, but not limited to storage space capacity requirements, computing capability requirements, or delay requirements. Optionally, it may be specifically that each group of second configuration information includes a performance requirement of a corresponding AI encoder. In some other embodiments, before S101, the method may further include: The network device sends performance requirements of the N AI encoders to the terminal. In some other embodiments, before S101, the method may further include: The network device determines, through negotiation with the terminal, performance requirements of the N AI encoders, that is, the performance requirements are predefined.

In the three cases, in some embodiments, the first configuration information may further include a standby encoding solution (namely, a solution in which encoding is performed by using a standby encoder), and optionally, a use manner of the standby encoding solution. In some other embodiments, before S101, the method may further include: The network device determines, through negotiation with the terminal, a standby encoding solution and optionally, a use manner of the standby encoding solution, that is, the standby encoding solution is predefined, and optionally, the use manner is predefined. In some other embodiments, before S101, the method may further include: The terminal receives a standby encoding solution and optionally, a usage manner, sent by the network device. The standby encoder may be, but is not limited to, an encoder based on a conventional encoding solution such as a codebook, or another AI encoder with better generalization.

For example, the use manner may include: When determining that there is no AI encoder to which the to-be-transmitted information is applicable, the terminal may use the standby encoder to encode the to-be-transmitted information; and/or although the terminal determines that there is the AI encoder to which the to-be-transmitted information is applicable, but the terminal does not receive the AI encoder, the terminal encodes the to-be-transmitted information by using the standby encoder; and/or although the terminal determines that there is the AI encoder to which the to-be-transmitted information is applicable, but performance of the terminal does not meet a performance requirement of the AI encoder, the terminal encodes the to-be-transmitted information by using the standby encoder.

S102: The terminal determines, based on the first configuration information, whether there is the AI encoder to which the first information is applicable.

Specifically, S102 is optional. Optionally, the terminal determines, based on the first configuration information, whether the to-be-transmitted first information is applicable to the to-be-applied AI encoder (namely, the any AI encoder in the N AI codecs). The first information is the to-be-transmitted information, and may be but is not limited to measurement information such as CSI, status information, and service data such as audio data and text data. Optionally, when N is equal to 1, the terminal may determine, based on the first configuration information, whether the first information is applicable to the AI encoder. Optionally, when N is greater than 1, the terminal may determine, based on the first configuration information, whether there is the AI encoder to which the first information is applicable in the N AI codecs (which may also be understood as N AI encoders), and optionally, the AI encoder to which the first information is applicable.

The N AI encoders may be sent by the network device to the terminal. Optionally, the network device may send the N AI encoders to the terminal before S102 or optionally after S102 (the terminal determines the AI encoder to which the to-be-transmitted information is applicable). Then, the terminal sends information to the network device to request to configure the AI encoder, and the network device sends the AI encoder to the terminal in response to the request from the terminal.

In some embodiments, the terminal may determine, based on the first configuration information, whether the performance requirements of the N AI encoders are met. If the performance requirements of the N AI encoders are not met, the terminal may determine that a used encoder is the standby encoder; or if the terminal determines that the performance requirements of the M AI encoders are met, the terminal may determine, based on the first configuration information, whether there is the AI encoder to which the first information is applicable in M AI encoders, where M is less than or equal to N. For example, if there is the AI encoder to which the first information is applicable in the M AI encoders, the terminal may determine that a used encoder is the AI encoder; or if there is no AI encoder to which the first information is applicable in the M AI encoders, the terminal may determine that a used encoder is the standby encoder. In some other embodiments, the terminal may first obtain, through determining, the AI encoder to which the first information is applicable, and then determine, based on the first configuration information, whether a performance requirement of the AI encoder is met. For example, when the performance requirement is not met, the terminal may determine that the used encoder is the standby encoder; or when the performance requirement is met, the terminal may determine that the used encoder is the AI encoder.

That the terminal meets the performance requirement of the AI encoder may include at least one of the following: The terminal meets a storage capability requirement of the AI encoder, the terminal meets a computing capability requirement of the AI encoder, and the terminal meets a delay requirement of the AI encoder. For example, when a locally available storage space of the terminal is greater than the storage space capacity requirement of the AI encoder, the terminal may determine that the storage capability requirement of the AI encoder is met. When a parameter (for example, a computing amount per unit time) that represents a computing capability of the terminal is greater than the computing capability requirement of the AI encoder, the terminal may determine that the computing capability requirement of the AI encoder is met. When a delay at which the terminal completes information encoding by using the AI encoder is less than the delay requirement of the AI encoder, the terminal may determine that the delay requirement of the AI encoder is met.

It should be noted that meeting the performance requirement of the AI encoder is only a prerequisite for using the AI encoder. That is, if the performance requirement of the AI encoder is not met, the AI encoder cannot be used; or if the performance requirement of the AI encoder is met, whether the AI encoder is used is determined based on an actual situation (for example, whether the terminal receives an indication of the AI encoder or the network device).

Descriptions are provided in subsequent embodiments by using an example in which the terminal meets the performance requirements of the N AI encoders.

For the first configuration information of different cases, manners in which the terminal determines whether there is the AI encoder to which the first information is applicable may be different. Specifically, the following three cases may be included.

Case 1: When the first configuration information is shown in Case 1 in S 101, and includes the mean of the training data sets, the terminal may compute a cosine similarity (cosine similarity, CS) between the first information and the mean. When the first configuration information is shown in Case 2 in S101, and includes the mean of the training data set on which the first preprocessing is performed, the terminal may first perform the first preprocessing on the first information, and then compute a cosine similarity between the mean and the information after the first preprocessing. Finally, the terminal may determine, based on the cosine similarity obtained through computing and the corresponding determining threshold, whether the first information is applicable to the to-be-applied AI encoder.

Optionally, when N is equal to 1, the terminal may compute a cosine similarity corresponding to the AI encoder, and determine, based on a relationship between the cosine similarity and the determining threshold, whether the first information is applicable to the AI encoder. For example, the group of determining thresholds that are predefined or indicated in the first configuration information includes one determining threshold $CS_t$. When the cosine similarity obtained through computing $CS_0 > CS_t$, it represents that the first information is applicable to the AI encoder (that is, it is applicable to the AI codec); otherwise, it represents that the first information is not applicable to the AI encoder. Alternatively, the group of determining thresholds includes two determining thresholds $CS_{t1}$ and $CS_{t2}$. When the cosine similarity obtained through computing $CS_0 < CS_{t1}$, it represents that the first information is not applicable to the AI encoder; or when the cosine similarity obtained through computing $CS_{t2} \geq CS_0 \geq CS_{t1}$, it represents that the first information is applicable to the AI encoder, and there is poor expected effect of applying the AI codec to perform encoding and decoding on the first information; or when the cosine similarity obtained through computing $CS_0 > CS_{t2}$, it indicates that the first information is applicable to the AI encoder, and there is good expected effect of applying the AI codec to perform encoding and decoding on the first information. The determining method predefined or indicated in the first configuration information may include: Only when $CS_0 > CS_{t2}$, it is determined that the applied encoder is the AI encoder; or when $CS_0 \geq CS_{t1}$, it is determined that the applied encoder is the AI encoder.

Optionally, when N is greater than 1, the terminal may separately compute cosine similarities corresponding to the N AI encoders, and determine, based on relationships between the N cosine similarities and the determining threshold, whether there is the AI encoder to which the first information is applicable, and optionally, the AI encoder to which the first information is applicable. A larger cosine similarity indicates that the first information is more applicable to the corresponding AI encoder, that is, there is better expected effect of applying the AI codec to perform encoding and decoding on the first information. When the cosine similarity and the determining threshold meet a preset threshold condition, the terminal may determine that the first information is applicable to the AI encoder corresponding to the cosine similarity. For an example of the preset threshold condition, refer to the foregoing determining threshold and the determining method when N is equal to 1. Optionally, the terminal may determine, when the cosine similarity and the determining threshold meet the preset threshold condition, an AI encoder corresponding to the largest cosine similarity as an AI encoder to which the first information is most applicable, that is, there is best expected effect of applying the AI codec to perform encoding and decoding on the first information.

Case 2: When the first configuration information is shown in Case 1 in S101, and includes the complete distribution parameter of the mathematical distribution (for example, includes means and variance matrices that can together form a multi-dimensional Gaussian distribution), the terminal may compute a probability parameter of the first information in the mathematical distribution, for example, a probability density function (probability density function, PDF) or a probability mass function (probability mass function, PMF). When the first configuration information is shown in Case 2 in S101, and includes the complete distribution parameter of the mathematical distribution on which the first preprocessing is performed, the terminal may first perform the first preprocessing on the first information to obtain the first processing information, and then compute a probability parameter of the first processing information in the mathematical distribution. Finally, the terminal may determine, based on the probability parameter obtained through computing and the corresponding determining threshold, whether the first information is applicable to the to-be-applied AI encoder.

Optionally, when N is equal to 1, the terminal may compute a probability parameter corresponding to the AI encoder, and determine, based on a relationship between the probability parameter and the determining threshold, whether the first information is applicable to the AI encoder. Optionally, when N is greater than 1, the terminal may separately compute probability parameters corresponding to the N AI encoders, and determine, based on relationships between the N probability parameters and the determining threshold, whether there is the AI encoder to which the first information is applicable, and optionally, the AI encoder to which the first information is applicable. A larger probability parameter indicates that the first information is more applicable to the corresponding AI encoder, that is, there is better expected effect of applying the AI codec to perform encoding and decoding on the first information. When the probability parameter and the determining threshold meet a preset threshold condition, the terminal may determine that the first information is applicable to the AI encoder corresponding to the probability parameter. Optionally, the terminal may determine, when the probability parameter and the determining threshold meet the preset threshold condition, an AI encoder corresponding to the largest probability parameter as an AI encoder to which the first information is most applicable, that is, there is best expected effect of applying the AI codec to perform encoding and decoding on the first information. A specific example is similar to the example shown in Case 1, and details are not described again.

Case 3: The first configuration information is shown in Case 3 in S101. Optionally, the terminal may set the input of the AI decider to the first information to obtain the output of the AI decider. Optionally, the terminal may perform the second preprocessing on the first information to obtain the second processing information, and then set the input of the AI decider to the second processing information, to obtain the output of the AI decider.

Optionally, the terminal may determine, based on the output of the AI decider, whether there is the AI encoder to which the first information is applicable.

Optionally, the AI decider has a single output port, that is, there is one output. Optionally, there are N outputs of the AI decider (for example, [1, N], where the outputs of the AI decider each are a positive integer). The N outputs respectively correspond to the N AI encoders. When the output of the AI decider is a value corresponding to a first AI encoder, it represents that the first AI encoder is the AI encoder to which the first information is applicable in the N AI encoders determined by the AI decider. Optionally, there are N+1 outputs of the AI decider (for example, [0, N], where the outputs of the AI decider each are a positive integer). The N outputs (for example, [1, N]) respectively correspond to the N AI encoders, and descriptions of the N outputs and the foregoing N outputs are consistent, and details are not described again. When the output of the AI decider is one output (for example, 0) different from the N outputs, it indicates that the AI decider determines that the first information is not applicable to the N AI encoders.

Optionally, the AI decider has N output ports, that is, there are N outputs, where the N outputs respectively correspond to the N AI encoders. Optionally, any one of the N outputs has two values (for example, 0 or 1), where one value (for example, 0) represents that the first information is not applicable to an AI encoder corresponding to the output, and the other one (for example, 1) represents that the first information is applicable to the AI encoder corresponding to the output.

Optionally, the AI decider has N+1 output ports, that is, there are N+1 outputs, where descriptions of the N outputs and the N outputs of the N output ports of the AI decider are consistent, and details are not described again. Optionally, the different output has two values (for example, 0 or 1), where one value (for example, 0) represents that the first information is not applicable to the N AI encoders, and the other value (for example, 1) represents that the first information is applicable to at least one of the N AI encoders.

Optionally, the terminal may determine, based on a relationship between the output of the AI decider and an output threshold, whether there is the AI encoder to which the first information is applicable.

Optionally, when N is equal to 1, the AI decider has the single output port, and the terminal may determine, based on the output of the AI decider, whether the first information is applicable to the AI encoder. For example, the output of the AI decider is 0 or 1. When the output is 1, the terminal may determine that the first information is applicable to the AI encoder; or when the output value is 0, the terminal may determine that the first information is not applicable to the AI encoder. Alternatively, a value range of the output of the AI decider is [0, 1]. A larger output indicates that the first information is more applicable to the AI encoder, that is, there is better expected effect of applying the AI codec to perform encoding and decoding on the first information. When the output is larger than the output threshold, the terminal may determine that the first information is applicable to the AI encoder; otherwise, the first information is not applicable to the AI encoder. This is not limited thereto. There may also be a plurality of output thresholds. A determining example is similar to that when there are the plurality of determining thresholds shown in Case 1 and Case 2, and details are not described again.

Optionally, when N is greater than 1, the AI decider has the plurality of output ports, and the N output ports each may output one probability, and probabilities may be expressed as $l_1, l_2, ... , l_N$. A higher probability $l_i$ output by an $i^{th}$ output port represents that the first information is more applicable to an AI encoder corresponding to the $i^{th}$ output port, that is, there is better expected effect of applying the AI codec corresponding to the $i^{th}$ output port to perform encoding and decoding on the first information, where a value range of i is [1, N]. When the probability is higher than the output threshold, that is, $l_i > l_t$, the terminal may determine that the first information is applicable to the AI encoder corresponding to the $i^{th}$ output port. When the probability is higher than the output threshold and higher than the probabilities output by the other (N-1) output ports, the terminal may determine that the first information is most applicable to the AI encoder corresponding to the $i^{th}$ output port, that is, there is best expected effect of applying the AI codec corresponding to the $i^{th}$ output port to perform encoding and decoding on the first information.

S103: The terminal encodes the first information by using a first encoder to obtain second information.

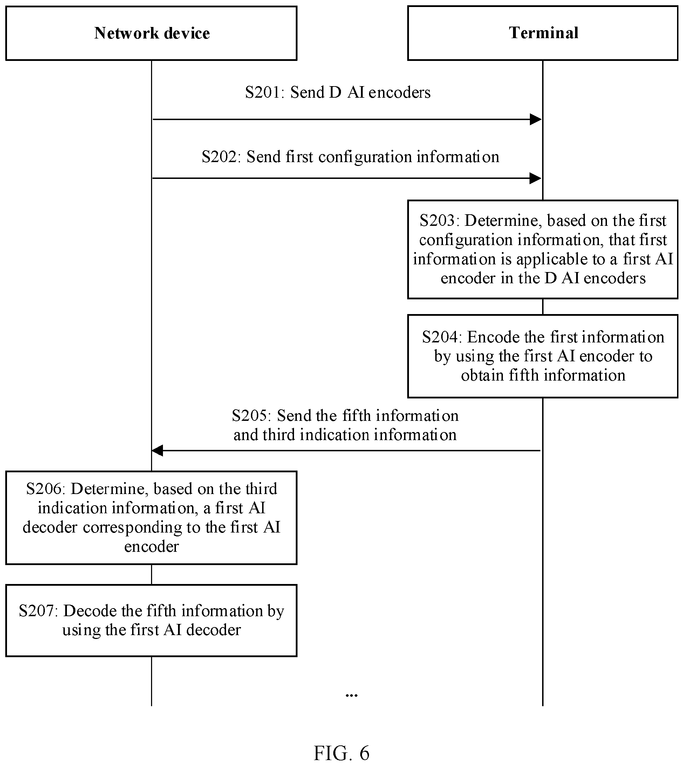

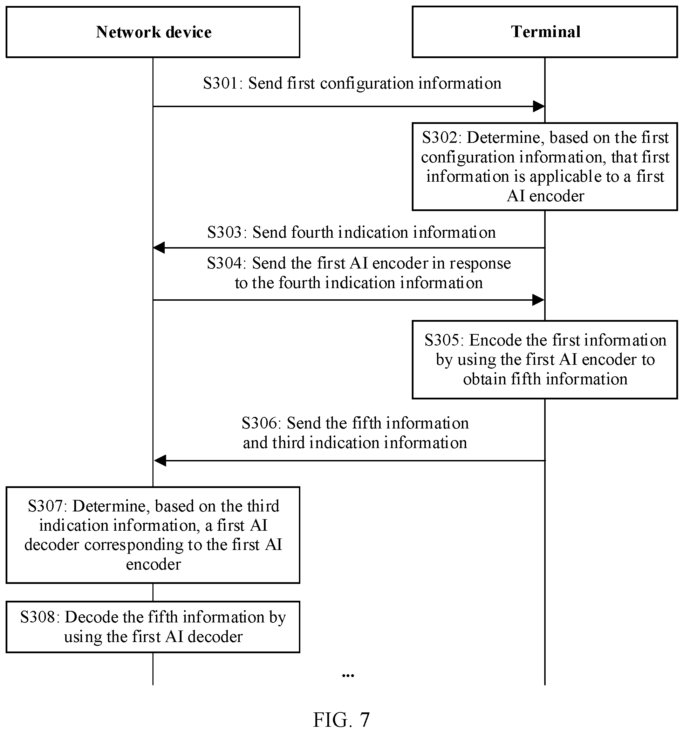

In some embodiments, the first encoder may be the AI encoder that is (most) applicable to the first information and that is determined by the terminal. Optionally, when the terminal determines that the first information is (most) applicable to the first encoder in the N AI encoders, and the terminal has received the first encoder before S103, the terminal may encode the first information by using the first encoder. For a specific procedure example, refer to FIG. 6 below. Optionally, when the terminal determines that the first information is (most) applicable to the first encoder in the N AI encoders, the terminal may send information to the network device, to request the network device to configure the first encoder. After receiving the first encoder, the terminal may encode the first information by using the first encoder. For a specific procedure example, refer to FIG. 7 below. Optionally, the terminal may directly use the first information as an input of the first encoder, to obtain the output second information. Optionally, the terminal may first perform the first preprocessing on the first information to obtain the first processing information, and then use the first processing information as an input of the first encoder to obtain the output second information.

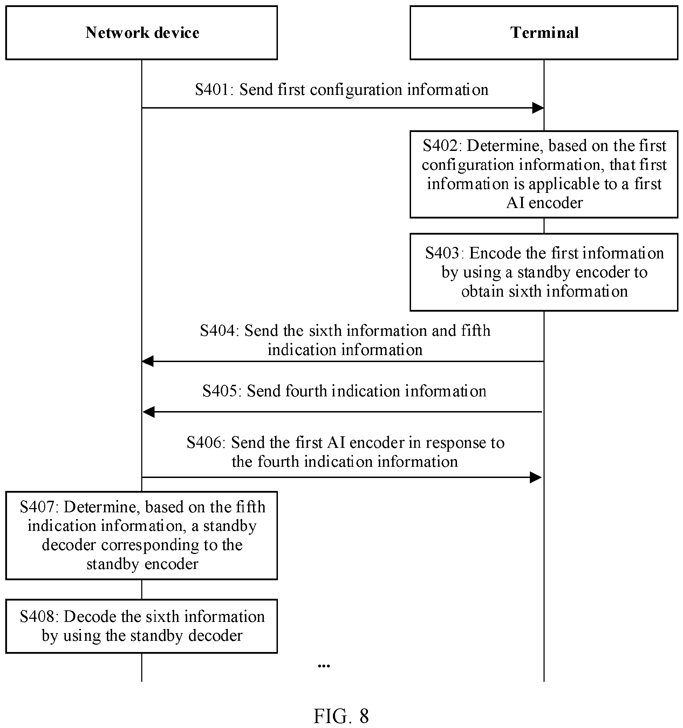

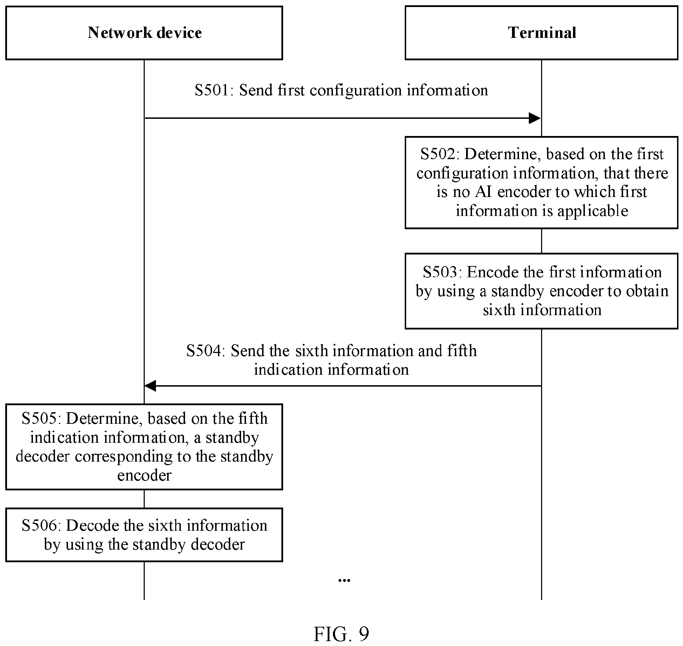

In some embodiments, the first encoder may be the standby encoder. Optionally, if the terminal determines that there is the AI encoder to which the first information is applicable in the N AI encoders, but the terminal does not receive the AI encoder, the terminal may use the first information as an input of the standby encoder to obtain an output. For a specific procedure example, refer to FIG. 8 below. Optionally, if the terminal determines that there is no AI encoder to which the first information is applicable in the N AI encoders, the terminal may use the first information as an input of the standby encoder to obtain an output. A specific procedure example is shown in FIG. 9 below.

The following shows two examples of the foregoing process of S101 to S103.

Example 1: It is assumed that N is equal to 1. The first configuration information obtained by the terminal is shown in Case 2 in S101, and may specifically include the mean $H_{TRN}$ of the training data sets (assumed as the CSI) of the AI codec after the first preprocessing, the first preprocessing information (namely, the first preprocessing includes Fourier transform (which can convert the training data set to an angle domain and a delay domain), and truncation on some high-delay data), the determining threshold $H_{Th}$, the standby encoder for encoding by using the codebook, and the use manner of the standby encoder (that is, the standby encoder is used when there is no AI encoder to which the to-be-transmitted information is applicable).

Correspondingly, a manner in which the terminal determines, based on the first configuration information, whether the first information is applicable to the to-be-applied AI encoder is shown in Case 1 in S102 in FIG. 5, and specifically is as follows: The terminal performs the first preprocessing on the first information, that is, performs Fourier transform on the first information to convert the first information to the angle domain and the delay domain, and then performs truncation on some high-delay data to obtain the first processing information $H_1$. Then, the terminal computes the cosine similarity $CS_H$ between the first processing information $H_1$ and the mean $H_{TRN}$. If $CS_H > H_{Th}$, the terminal may determine that the first information is applicable to the AI encoder, and determine that the used encoder (namely, the first encoder) is the AI encoder. In this case, in S103, the terminal may use the first processing information $H_1$ as the input of the AI encoder, to obtain an output $H_{FB}$. Alternatively, if $CS_H \leq H_{Th}$, the terminal may determine that the first information is not applicable to the AI encoder, and determine that the used encoder is the standby encoder. In this case, in S103, the terminal may encode the first information by using the standby encoder.

Optionally, if N is greater than 1, an example in which the terminal determines whether there is the AI encoder to which the to-be-transmitted information is applicable in the N AI encoders is similar to the foregoing example, and a difference lies in: The terminal may further determine, from at least one AI encoder whose cosine similarity is greater than the determining threshold, an AI encoder with the largest cosine similarity. The AI encoder is an AI encoder that is most applicable to the first information and that is determined by the terminal, and is also the used encoder.

Example 2: It is assumed that N is greater than 1. The first configuration information obtained by the terminal is shown in Case 3 in S101, and may specifically include the AI decider with the N output ports (the N output ports respectively correspond to N AI codecs, which may also be understood as corresponding to N AI encoders), the output threshold Th, the method for determining, based on the output threshold and the outputs of the AI decider, whether there is the AI encoder to which the to-be-transmitted information (assuming that the information is the CSI) is applicable in the N AI encoders (that is, when an output of an output port of the AI decider is greater than the output threshold Th and is greater than the outputs of the other (N-1) output ports, the to-be-transmitted information is applicable to the AI encoder corresponding to the port), the first preprocessing information (that is, the first preprocessing includes Fourier transform, truncation on some high-delay data), the second preprocessing information (the second preprocessing is consistent with the first preprocessing), the standby encoder for encoding by using the codebook, and the use manner of the standby encoder (that is, the standby encoder is used when there is no AI encoder to which the to-be-transmitted information is applicable).

Correspondingly, a manner in which the terminal determines, based on the first configuration information, whether there is the AI encoder to which the first information is applicable in the N AI encoders is shown in Case 3 in S102, and specifically is as follows: The terminal performs the second preprocessing on the first information, that is, performs Fourier transform on the first information to convert the first information to an angle domain and a delay domain, and then performs truncation on some high-delay data to obtain the second processing information $H_2$. Then, the terminal uses the second processing information $H_2$ as the input of the AI decider, to obtain the outputs $I_1$, $I_2$, ... , $I_N$ of the N output ports. If $I_i > Th$ and $I_i > I_j$, where a value range of i is [1, N], a value range of j is [1, N], and j is different from i, the terminal may determine that the first information is applicable to the AI encoder corresponding to the i$^{th}$ output port, and determine that the used encoder is the AI encoder. In this case, in S103, the terminal may perform the first preprocessing on the first information, to obtain the first processing information $H_1$. The first preprocessing is consistent with the second preprocessing, and therefore, the first processing information $H_1$ is the same as the second processing information $H_2$. Then, the terminal may use the first processing information as the input of the AI encoder, to obtain the output $H_{FB}$. If an output of any output port is less than or equal to Th, the terminal may determine that the first information is not applicable to the N AI encoders, and determine that the used encoder is the standby encoder. In this case, in S103, the terminal may encode the first information by using the standby encoder.

S104: The terminal sends the second information and first indication information to the network device.

Optionally, the terminal may not send first indication information to the network device.

Optionally, the first indication information may indicate whether the terminal uses the AI encoder. When the first indication information indicates that the terminal uses the AI encoder, the first indication information further indicates the AI encoder specifically used by the terminal, for example, including an identifier of the AI codec to which the terminal determines that the first information is applicable. In this case, the first encoder is the AI encoder. When the first indication information indicates that the terminal does not use the AI encoder, the first indication information further indicates that the terminal uses the standby encoder, that is, the first encoder is the standby encoder. Alternatively, the network device may obtain the following information based on the first indication information: The second information is obtained by the terminal through encoding by using the first encoder, and optionally, the first encoder is the AI encoder to which the first information is (most) applicable and that is determined by the terminal.

S105: The network device determines, based on the first indication information, a first decoder corresponding to the first encoder.

Specifically, S105 is optional. Optionally, the network device may determine, based on the first indication information, the first encoder used by the terminal, and optionally, determine the first decoder corresponding to the first encoder.

For example, the first encoder is an AI encoder, and the first decoder is an AI decoder. The first indication information includes the identifier of the AI codec. The network device may determine, based on the identifier, that the first encoder is the AI encoder in the AI codec, and determine, based on the identifier, that the AI decoder corresponding to the AI encoder is a first decoder. Alternatively, the first encoder is the standby encoder, and the first decoder is a corresponding standby decoder. The first indication information includes an identifier of the first encoder. The network device may determine, based on the identifier, that the first encoder is an encoder that uses a codebook encoding solution, and determine, as the first decoder, a decoder that corresponds to the encoder and that uses a codebook decoding solution.

S106: The network device decodes the second information by using the first decoder.

Specifically, S106 is optional. S102 to S106 are a transmission process of the first information, namely, an information transmission process. S102 may be first determining performed by the terminal after the first configuration information is obtained.

S107: The terminal determines, based on the first configuration information, whether there is an AI encoder to which third information is applicable.

S108: The terminal encodes the third information by using a second encoder to obtain fourth information.

S109: The terminal sends the fourth information and second indication information to the network device.

S110: The network device determines, based on the second indication information, a second decoder corresponding to the second encoder.

S111: The network device decodes the fourth information by using the second decoder.

Optionally, S107 to S111 are a second information transmission process, and are also one information transmission process. The process is specifically similar to the transmission process shown in S102 to S106, and a difference lies in that a transmission moment is different from a transmission moment of the first information. S107 may be second determining performed by the terminal after the first configuration information is obtained. Optionally, in specific implementation, the terminal may continuously obtain the to-be-transmitted information, and perform a determining process periodically or in a triggering manner, that is, determine, based on the first configuration information, whether there is the AI encoder to which the to-be-transmitted information is applicable. The triggering manner means that determining is performed each time the to-be-transmitted information is obtained. Optionally, the terminal may select a used encoder based on a determining result, that is, the terminal may perform a plurality of information transmission processes. Each information transmission process is similar to a last transmission process. However, because to-be-transmitted information may be different, a determining result and a used encoder of each determining may be different. For example, the first information and the third information may not be identically distributed. In this case, determining results in S102 and S107 may be different, and the first encoder and the second encoder may be different (the first decoder and the second decoder are also different). For an example of each information transmission process, refer to S203 to S207 in FIG. 6, S302 to S308 in FIG. 7, S402 to S408 in FIG. 8, and S502 to S506 in FIG. 9.

In the method shown in FIG. 5, the terminal can determine whether there is the AI encoder to which the to-be-transmitted information is applicable, that is, determine whether the to-be-transmitted information and the training data sets of the AI codec are identically distributed. This avoids uncontrollable performance deterioration of the communication system and information distortion caused by encoding and decoding, by using the AI codec, the information that is not identically distributed with the training data sets. In addition, there is usually a large amount of to-be-transmitted information, and the terminal can quickly and flexibly switch the used encoders based on different to-be-transmitted information. Compared with a solution in which the terminal sends unencoded or high-fidelity encoded information to the network device, and the network device determines and indicates an encoder used by the terminal, the solution in which the terminal determines the encoder has smaller transmission overheads, and a shorter delay.

In some embodiments, before the terminal determines, based on the first configuration information, whether there is the AI encoder to which the to-be-transmitted information is applicable, the network device may send D AI encoders to the terminal, where D is a positive integer, and D is less than or equal to N. In this case, for an example of an information transmission process (namely, S102 to S106 in FIG. 5), refer to FIG. 6.

FIG. 6 is a schematic flowchart of another information encoding control method according to an embodiment of this application. The method may include but is not limited to the following steps.

S201: A network device sends D AI encoders to a terminal.

Specifically, S201 is optional.

In some embodiments, before S201, the method may further include: The terminal reports a performance parameter of the terminal to the network device, and the network device determines, based on the performance parameter of the terminal, whether the terminal meets performance requirements of N AI encoders. The D AI encoders are AI encoders that are of the N AI encoders and that are determined by the network device and that meet a performance requirement of the terminal, where D is less than or equal to N. This is not limited thereto. Alternatively, the network device may directly send the N AI encoders obtained by the network device to the terminal. In this case,

D is equal to N.

S202: The network device sends first configuration information to the terminal.

Specifically, S202 is optional. Optionally, the first configuration information may include statistical information of the N AI encoders, or may include statistical information of the D AI encoders. For a description of the first configuration information, refer to the description of S101 in FIG. 5, and details are not described again.

S203: The terminal determines, based on the first configuration information, that first information is applicable to a first AI encoder in the D AI encoders.

Specifically, S203 is optional. A determining process shown in S203 is similar to that in S102 in FIG. 5. A difference lies in that the terminal may perform determining based on the D AI encoders instead of the N AI encoders, and a determining result is that the terminal determines that there is an AI encoder to which the first information is applicable, and the AI encoder is the first AI encoder.

S204: The terminal encodes the first information by using the first AI encoder to obtain fifth information

Specifically, S204 is consistent with S103 in FIG. 5, except that the first encoder in S103 is the first AI encoder in S204.

S205: The terminal sends the fifth information and third indication information to the network device.

Optionally, the terminal may not send third indication information to the network device.

Optionally, the third indication information may indicate that the terminal uses the AI encoder, and the AI encoder used by the terminal is the first AI encoder. Optionally, the network device may obtain the following information based on the third indication information: The fifth information is obtained by the terminal by using the first AI encoder, and optionally, the first AI encoder is an AI encoder to which the first information is (most) applicable and that is determined by the terminal.

S206: The network device determines, based on the third indication information, a first AI decoder corresponding to the first AI encoder.

Specifically, S206 is optional. Optionally, the network device may determine, based on first indication information, the first AI encoder used by the terminal, and optionally, determine the first AI decoder corresponding to the first AI encoder.

S207: The network device decodes the fifth information by using the first AI decoder.

Specifically, S207 is optional.

Optionally, after S207, the terminal may further perform another information transmission process. For example, it is assumed that the terminal obtains to-be-transmitted third information, the terminal may determine, based on the first configuration information, whether there is an AI encoder to which the third information is applicable in the D AI encoders. Optionally, if there is the AI encoder to which the third information is applicable, for example, a first AI encoder (the terminal has received the first AI encoder), the terminal may encode the third information by using the AI encoder, and send, to the network device, indication information indicating that the AI encoder is used. Optionally, if there is the AI encoder to which the third information is applicable and the terminal does not receive the AI encoder, the terminal may send information to the network device, to request the network device to configure the AI encoder, then encode the third information by using the AI encoder, and send, to the network device, indication information indicating that the AI encoder is used. A specific process is similar to that in S302 to S308 in FIG. 7 below. Optionally, although there is the AI encoder to which the third information is applicable, the terminal does not receive the AI encoder, the terminal may encode the third information by using a standby encoder, and send, to the network device, indication information indicating that the standby encoder is used. A specific process is similar to that in S402 to S408 in FIG. 8 below. Optionally, if there is no AI encoder to which the third information is applicable, the terminal may fall back to a standby encoding solution based on the first configuration information, that is, encode the third information by using a standby encoder, and send, to the network device, indication information indicating that the standby encoder is used. A specific process is similar to that in S502 to S506 in FIG. 9 below.

This is not limited to the foregoing enumerated cases. In specific implementation, if D is less than N, the terminal may still determine, based on the N AI encoders, whether there is the AI encoder to which to-be-transmitted information is applicable. When the terminal determines that the to-be-transmitted information is applicable to an AI encoder X (belongs to one AI encoder different from the D AI encoders in the N AI encoders), the terminal may send information to the network device, to request the network device to configure the AI encoder X, and then perform encoding by using the AI encoder X. A specific process is similar to that in S302 to S308 in FIG. 7 below. Alternatively, the terminal may perform encoding by using a standby encoder. A specific process is similar to that in S402 to S408 in FIG. 8 below.

In some embodiments, when the terminal determines that the to-be-transmitted information is applicable to the first AI encoder, and the terminal does not receive the first AI encoder, the terminal may send information to the network device, to request the network device to configure the first AI encoder, and then encode the to-be-transmitted information by using the first AI encoder. In this case, for an example of an information transmission process (namely, S102 to S106 in FIG. 5), refer to FIG. 7 below.

FIG. 7 is a schematic flowchart of still another information encoding control method according to an embodiment of this application. The method may include but is not limited to the following steps.

S301: A network device sends first configuration information to a terminal.

Specifically, S301 is optional. For a description of the first configuration information, refer to the description of S101 in FIG. 5, and details are not described again.

S302: The terminal determines, based on the first configuration information, that first information is applicable to a first AI encoder.

Specifically, S302 is optional. A determining process shown in S302 is the same as that in S102 in FIG. 5, except that a determining result is that the terminal determines that there is an AI encoder to which the first information is applicable, and the AI encoder is the first AI encoder. Because the terminal does not receive the first AI encoder, the terminal may send information to the network device, to request the network device to configure the first AI encoder, that is, perform S303.

S303: The terminal sends fourth indication information to the network device.

Specifically, S303 is optional.

For example, the fourth indication information may include an identifier of an AI codec in which the first AI encoder is located. The network device may determine, based on the identifier, that the encoder requested by the terminal to be configured is an AI encoder in the AI codec.

S304: The network device sends the first AI encoder to the terminal in response to the fourth indication information.

Specifically, S304 is optional.

In some embodiments, if the terminal reports a performance parameter to the terminal before S304, after receiving the fourth indication information, the network device may first determine, based on the performance parameter of the terminal, whether the terminal meets a performance requirement of the first AI encoder, and may directly send the first AI encoder when the terminal meets the performance requirement; otherwise, the network device may send corresponding indication information (for example, an indication that the performance requirement is not met) to the terminal.

S305: The terminal encodes the first information by using the first AI encoder to obtain fifth information

S306: The terminal sends the fifth information and third indication information to the network device.

Optionally, the terminal may not send third indication information to the network device.

S307: The network device determines, based on the third indication information, a first AI decoder corresponding to the first AI encoder.

Specifically, S307 is optional.

S308: The network device decodes the fifth information by using the first AI decoder.

Specifically, S308 is optional. S305 to S308 are consistent with S204 to S207 in FIG. 6, and details are not described again.

This is not limited to the foregoing enumerated cases. In specific implementation, the fourth indication information may further include a determining result in S302, that is, indicate that the terminal determines that the first information is (most) applicable to the first AI encoder. Alternatively, the terminal may not send third indication information in S306, and the network device may determine, based on the fourth indication information sent by the terminal, the AI encoder required by the terminal.

Optionally, after S308, the terminal may further perform another information transmission process. For example, it is assumed that the terminal obtains to-be-transmitted third information, the terminal may determine, based on the first configuration information, whether there is an AI encoder to which the third information is applicable in N AI encoders. Optionally, if there is the AI encoder to which the third information is applicable and the AI encoder is a first AI encoder (the terminal has received the first AI encoder), the terminal may not need to send, to the network device, information to request to configure the first AI encoder, but directly encode the third information by using the first AI encoder, and send, to the network device, indication information indicating that the first AI encoder is used. This reduces a transmission delay. A specific process is similar to that in S203 to S207 in FIG. 6. Optionally, if there is the AI encoder to which the third information is applicable and the terminal does not receive the AI encoder, the terminal may send information to the network device again, to request the network device to configure the AI encoder, then encode the third information by using the AI encoder, and send, to the network device, indication information indicating that the AI encoder is used. Optionally, although there is the AI encoder to which the third information is applicable, the terminal does not receive the AI encoder, the terminal may encode the third information by using a standby encoder, and send, to the network device, indication information indicating that the standby encoder is used. A specific process is similar to that in S402 to S408 in FIG. 8 below. Optionally, if there is no AI encoder to which the third information is applicable, the terminal may fall back to a standby encoding solution based on the first configuration information, that is, encode the third information by using a standby encoder, and send, to the network device, indication information indicating that the standby encoder is used. A specific process is similar to that in S502 to S506 in FIG. 9 below.

In some embodiments, when the terminal determines that the to-be-transmitted information is applicable to the first AI encoder, and the terminal does not receive the first AI encoder, the terminal may first encode the to-be-transmitted information by using a standby encoder. This reduces a transmission delay and avoids affecting a subsequent information transmission process. In this case, for an example of an information transmission process (namely, S102 to S106 in FIG. 5), refer to FIG. 8.

FIG. 8 is a schematic flowchart of yet another information encoding control method according to an embodiment of this application. The method may include but is not limited to the following steps.

S401: A network device sends first configuration information to a terminal.

Specifically, S401 is optional. For a description of the first configuration information, refer to the description of S101 in FIG. 5, and details are not described again.

S402: The terminal determines, based on the first configuration information, that first information is applicable to a first AI encoder.

Specifically, S402 is optional. A determining process shown in S402 is the same as that in S102 in FIG. 5, except that a determining result is that the terminal determines that there is an AI encoder to which the first information is applicable, and the AI encoder is the first AI encoder. Because the terminal does not receive the first AI encoder, the terminal may send information to the network device, to request the network device to configure the first AI encoder, that is, perform S405.

S403: The terminal encodes the first information by using a standby encoder to obtain sixth information

S404: The terminal sends the sixth information and fifth indication information to the network device.

Optionally, the fifth indication information may indicate that the terminal uses the standby encoder, and optionally, the terminal does not use an AI encoder. Optionally, the network device may obtain, based on the fifth indication information, that the sixth information is obtained by the terminal by using the standby encoder.

Optionally, the terminal may not send fifth indication information to the network device.

S405: The terminal sends fourth indication information to the network device.

Specifically, S405 is optional.

For example, the fourth indication information may include an identifier of an AI codec in which the first AI encoder is located. The network device may determine, based on the identifier, that the encoder requested by the terminal to be configured is an AI encoder in the AI codec.

For example, the terminal identifies that recently to-be-transmitted information is similar. For example, the terminal is indoors in a stadium within 10 minutes, and when a user moves indoors in the stadium, to-be-transmitted CSI of the terminal is identically distributed. Therefore, the terminal can request, by using the fourth indication information, the network device to configure the first AI encoder, so that the information applicable to the first AI encoder can be directly encoded by using the first AI encoder subsequently, without requesting again, thereby reducing a transmission delay.

S406: The network device sends the first AI encoder to the terminal in response to the fourth indication information.

Specifically, S406 is optional.

In some embodiments, if the terminal reports a performance parameter to the terminal before S304, after receiving the fourth indication information, the network device may first determine, based on the performance parameter of the terminal, whether the terminal meets a performance requirement of the first AI encoder, and may directly send the first AI encoder when the terminal meets the performance requirement; otherwise, the network device may send corresponding indication information (for example, an indication that the performance requirement is not met) to the terminal.

Optionally, although the terminal determines that the first information is (most) applicable to the first AI encoder, because the terminal does not receive the first AI encoder, the terminal may encode the first information by using the standby encoder (that is, perform S403), and optionally may send the information to the network device, to request to configure the first AI encoder (that is, perform S405). It should be noted that S406 is after S403 and S405, but a specific moment at which the network device sends the first AI encoder is not limited. For example, a sequence of S406 and S404, S407, and S408 is not limited.

A sequence of S403 and S405 is not limited. In some embodiments, the terminal may first perform encoding and then request to configure the first AI encoder, that is, S403 is before S405, but in this case, a sequence of sending, by the terminal, the sixth information obtained after encoding and requesting to configure the first AI encoder is not limited. That is, a sequence of S404 and S405 is not limited. In some other embodiments, the terminal may first send the information to the network device, to request to configure the first AI encoder, and then perform encoding before receiving the first AI encoder, that is, S405 is before S403, and S406 is after S403.

S407: The network device determines, based on the fifth indication information, a standby decoder corresponding to the standby encoder.

Specifically, S407 is optional.

S408: The network device decodes the sixth information by using the standby decoder.

Specifically, S408 is optional.

Optionally, after S408, the terminal may further perform another information transmission process. For example, it is assumed that the terminal obtains to-be-transmitted third information, the terminal may determine, based on the first configuration information, whether there is an AI encoder to which the third information is applicable in N AI encoders. Optionally, if there is the AI encoder to which the third information is applicable and the AI encoder is a first AI encoder (the terminal has received the first AI encoder), the terminal may not need to send, to the network device, information to request to configure the first AI encoder, but directly encode the third information by using the first AI encoder, and send, to the network device, indication information indicating that the first AI encoder is used. This reduces a transmission delay. A specific process is similar to that in S203 to S207 in FIG. 6. Optionally, if there is the AI encoder to which the third information is applicable and the terminal does not receive the AI encoder, the terminal may send information to the network device, to request to configure the AI encoder, then encode the third information by using the AI encoder, and send, to the network device, indication information indicating that the AI encoder is used. A specific process is similar to that in S302 to S308 in FIG. 7. Optionally, although there is the AI encoder to which the third information is applicable, the terminal does not receive the AI encoder, the terminal may encode the third information by using a standby encoder, and send, to the network device, indication information indicating that the standby encoder is used. This reduces a transmission delay and ensures that a process of feeding back information encoding is not interrupted. Optionally, if there is no AI encoder to which the third information is applicable, the terminal may fall back to a standby encoding solution based on the first configuration information, that is, encode the third information by using a standby encoder, and send, to the network device, indication information indicating that the standby encoder is used. A specific process is similar to that in S502 to S506 in FIG. 9 below.

In some embodiments, when the terminal determines that there is no AI encoder to which the to-be-transmitted information is applicable in the N AI encoders, the terminal may encode the to-be-transmitted information by using a standby encoder. This avoids performance deterioration of the communication system and transmission distortion caused by misusing an AI encode. In this case, for an example of an information transmission process (namely, S102 to S106 in FIG. 5), refer to FIG. 9 below.

FIG. 9 is a schematic flowchart of still yet another information encoding control method according to an embodiment of this application. The method may include but is not limited to the following steps.

S501: A network device sends first configuration information to a terminal.

Specifically, S501 is optional. For a description of the first configuration information, refer to the description of S101 in FIG. 5, and details are not described again.

S502: The terminal determines, based on the first configuration information, that there is no AI encoder to which first information is applicable.

Specifically, S502 is optional. A determining process shown in S502 is the same as S102 in FIG. 5, except that a determining result is that the terminal determines that there is no AI encoder to which the first information is applicable.

S503: The terminal encodes the first information by using a standby encoder to obtain sixth information.

S504: The terminal sends the sixth information and fifth indication information to the network device.

Optionally, the fifth indication information may indicate that the terminal uses the standby encoder, and optionally, the terminal does not use an AI encoder. Optionally, the network device may obtain, based on the fifth indication information, that the sixth information is obtained by the terminal by using the standby encoder.

Optionally, the terminal may not send fifth indication information to the network device.

S505: The network device determines, based on the fifth indication information, a standby decoder corresponding to the standby encoder.

Specifically, S505 is optional.

S506: The network device decodes the sixth information by using the standby decoder.

Specifically, S506 is optional.

Optionally, the standby encoder may be an encoder based on a conventional encoding solution such as a codebook, or may be another AI encoder with better generalization. If the standby encoder is the another AI encoder with better generalization, the standby encoder may be sent by the network device before the terminal determines whether there is the AI encoder to which the to-be-transmitted information is applicable, or may be sent by the network device after the terminal determines whether there is the AI encoder to which the to-be-transmitted information is applicable.

Optionally, after S506, the terminal may further perform another information transmission process. For example, it is assumed that the terminal obtains to-be-transmitted third information, the terminal may determine, based on the first configuration information, whether there is an AI encoder to which the third information is applicable in N AI encoders. Optionally, if there is the AI encoder to which the third information is applicable and the terminal has received the AI encoder, the terminal may not need to send, to the network device, information to request to configure the AI encoder, but directly encode the third information by using the AI encoder, and send, to the network device, indication information indicating that the AI encoder is used. A specific process is similar to that in S203 to S207 in FIG. 6. Optionally, if there is the AI encoder to which the third information is applicable and the terminal does not receive the AI encoder, the terminal may send information to the network device, to request to configure the AI encoder, then encode the third information by using the AI encoder, and send, to the network device, indication information indicating that the AI encoder is used. A specific process is similar to that in S302 to S308 in FIG. 7. Optionally, although there is the AI encoder to which the third information is applicable, the terminal does not receive the AI encoder, the terminal may encode the third information by using a standby encoder, and send, to the network device, indication information indicating that the standby encoder is used. A specific process is similar to that in S402 to S408 in FIG. 8. Optionally, if there is no AI encoder to which the third information is applicable, the terminal may continue encoding the third information by using a standby encoder, and send, to the network device, indication information indicating that the standby encoder is used.

In a possible implementation, after determining whether there is the AI encoder to which the to-be-transmitted information (for example, after S102 in FIG. 5) is applicable, the terminal may report, to the network device, a determining result obtained in this determining process and optionally, a related parameter. The network device decides the encoder used by the terminal. A specific example is shown in FIG. 10.

FIG. 10 is a schematic flowchart of a further information encoding control method according to an embodiment of this application. The method may include but is not limited to the following steps.

S601: A network device sends first configuration information to a terminal.

Specifically, S601 is optional. For a description of the first configuration information, refer to the description of S101 in FIG. 5. In some embodiments, the first configuration information may further include a determining criterion. In some other embodiments, before S601, the method may further include: The network device determines, through negotiation with the terminal, the determining criterion, that is, the determining criterion is predefined. In some other embodiments, before S601, the method may further include: The terminal receives the determining criterion sent by the network device. The determining criterion is specific to a determining process (for example, S102 in FIG. 5 or S602) in which the terminal determines, based on a determining threshold, whether there is an AI encoder to which to-be-transmitted information is applicable. The determining criterion may be a soft decision criterion or a hard decision criterion.

S602: The terminal determines, based on the first configuration information, whether there is an AI encoder to which first information is applicable.

Specifically, S602 is optional. Optionally, S602 is similar to S102 in FIG. 5, and a difference lies in that in S102 in FIG. 5, the terminal performs determining by the terminal and makes a decision of the final encoder; and therefore, a determining criterion is the hard decision criterion by default, and a final determining result is a decision result (an encoder, namely, the used encoder). However, in S602, the terminal only performs determining by the terminal but does not make a decision. When the determining criterion is the hard decision criterion, a determining result is also one encoder. However, when the determining criterion is the soft decision criterion, there may be a plurality of determining results, and any one determining result corresponds to one AI encoder and indicates whether the to-be-transmitted information is applicable to the AI encoder.

S603: The terminal sends first determining information to the network device.

Specifically, S603 is optional. Optionally, the first determining information may include a determining result, and optionally, a related parameter obtained in a determining process (namely, S602), for example, a cosine similarity, a probability parameter, and an output of an AI decider that are obtained.

Optionally, when the terminal performs determining by using the hard decision criterion, if the terminal determines that there is the AI encoder to which the to-be-transmitted information is applicable, the first determining information may include an identifier of an AI codec in which the AI encoder is located and an indication (namely, the determining result) representing that the to-be-transmitted information is applicable to the AI encoder. If the terminal determines that there is no AI encoder to which the to-be-transmitted information is applicable, the first determining information may include an indication (namely, the determining result) representing that the to-be-transmitted information is not applicable to any AI encoder.

Optionally, when the terminal performs determining by using the soft decision criterion, optionally, the first determining information may include an indication of whether the to-be-transmitted information is applicable to the N AI encoders, or probabilities that the to-be-transmitted information is applicable to the N AI encoders (namely, N determining results), and indicators representing trustworthiness of the N determining results. Optionally, the first determining information may include an indication of S AI encoders to which the to-be-transmitted information is applicable (namely, S determining results, where S is less than or equal to N) and indicators representing degrees to which the to-be-transmitted information is applicable to the S AI encoders. For example, the first determining information may include that the to-be-transmitted information is applicable to two AI encoders (an AI encoder 1 and an AI encoder 2), and that indicators of degrees that the to-be-transmitted information is applicable to the AI encoder 1 and the AI encoder 2 are 1 and 2, where a larger indicator indicates a higher applicability degree. Therefore, the to-be-transmitted information is more applicable to the AI encoder 2.

Optionally, a method for determining, by the terminal, whether there is the AI encoder to which the first information is applicable is shown in Case 1 in S 102 in FIG. 5. The first determining information may further include the obtained cosine similarities, for example, largest S cosine similarities between the first information and statistical information of the N AI encoders, where S is a positive integer, and $1 \leq S \leq N$. Optionally, a method for determining, by the terminal, whether there is the AI encoder to which the first information is applicable is shown in Case 2 in S102 in FIG. 5. The first determining information may further include obtained probability parameters, for example, T largest PDFs in N PDFs obtained through computing by using statistical information of N AI encoders and the first information, where T is a positive integer, and $1 \leq T \leq N$. Optionally, a method for determining, by the terminal, whether there is the AI encoder to which the first information is applicable is shown in Case 3 in S102 in FIG. 5. The first determining information may further include an output of at least one output port of the AI decider, for example, outputs of N output ports, or an output greater than an output threshold, or Y largest outputs in N outputs, where Y is a positive integer, and $1 \leq Y \leq N$.

S604: The network device determines a third encoder based on the first determining information
Specifically, S604 is optional. Optionally, the third encoder is an AI encoder or a standby encoder. Optionally, when the terminal performs determining by using the hard decision criterion, optionally, if the terminal determines that there is the AI encoder to which the to-be-transmitted information is applicable, the network device may decide, based on an actual situation (for example, whether the terminal meets a performance requirement of the AI encoder), whether an encoder used by the terminal is the AI encoder or the standby encoder. Optionally, if the terminal determines that there is no AI encoder to which the to-be-transmitted information is applicable, the network device may decide that an encoder used by the terminal is the standby encoder. Optionally, when the terminal performs determining by using the soft decision criterion, the network device may decide, with reference to an actual situation (for example, whether the terminal meets a performance requirement of the AI encoder) and the first determining information, an encoder used by the terminal. A deciding manner is consistent with a manner of deciding, by the terminal, the encoder used by the terminal in S102 in FIG. 5, and details are not described again.

S605: The network device sends sixth indication information and the third encoder to the terminal.

Specifically, S605 is optional. Optionally, the sixth indication information indicates the terminal to perform encoding by using the third encoder

S606: The terminal encodes the first information by using the third encoder to obtain seventh information

In some embodiments, the third encoder is an AI encoder, and the terminal may first perform first preprocessing on the first information, and then input information after the first preprocessing into the AI encoder to obtain the output seventh information.

In some embodiments, the third encoder is an AI encoder, and the sixth indication information may include first preprocessing information corresponding to the AI encoder. The terminal may first perform first preprocessing on the first information, and then input information after the first preprocessing into the AI encoder to obtain the output seventh information.

S607: The terminal sends the seventh information to the network device.

S608: The network device decodes the seventh information by using a third decoder corresponding to the third encoder.

Specifically, S608 is optional. Optionally, because the network device sends the sixth indication information to the terminal, the network device may consider by default that the third encoder indicated in the sixth indication information is the encoder used by the terminal. Optionally, the network device may directly decode the seventh information by using the third decoder corresponding to the third encoder.

In some embodiments, S607 may further include information indicating that the encoder used by the terminal to encode the seventh information is the third encoder. The network device may determine, based on the information, the third decoder corresponding to the third encoder, and decode the seventh information by using the third decoder.

In some embodiments, before the terminal determines, based on the first configuration information, whether there is the AI encoder to which the to-be-transmitted information is applicable, the network device may send the AI encoder to the terminal. For example, before S601, the network device sends D AI encoders to the terminal, and in S605, the network device may not need to send the third encoder (AI encoder). A specific process is similar to that in FIG. 6, and details are not described again.

In some embodiments, if the network device does not send the third encoder to the terminal in S605, and the third encoder is an AI encoder, the terminal may send information to the network device after receiving the sixth indication information, to request to configure the third encoder. For example, the indication information for requesting to configure the third encoder is sent to the network device after S605 and before S606. A specific process is similar to that in FIG. 7, and details are not described again.

In some embodiments, if the third encoder is a standby encoder, the network device may not send the third encoder in S605.

Optionally, after S608, the terminal may further perform another information transmission process. In any information transmission process in the another information transmission process, in the same way as S602 to S608, the terminal determines and the network device decides the encoder used by the terminal, or in the same way as S102 to S106 in FIG. 5, the terminal determines and decides the encoder used by the terminal, for example, as shown in S203 to S207 in FIG. 6, S302 to S308 in FIG. 7, S402 to S408 in FIG. 8, and S502 to S506 in FIG. 9.

In the method shown in FIG. 10, the network device may decide the encoder used by the terminal. This reduces processing pressure of the terminal. In addition, the terminal may not need to send information indicating the used encoder. This reduces transmission overheads. If the decided encoder used by the terminal is an AI encoder that is not sent by the network device, the network device may directly send the AI encoder, and the terminal does not need to send information for requesting to configure the AI encoder. This reduces transmission overheads.

In some embodiments, the network device may generate an AI codec through training. A training data set used when the network device trains the AI codec may be to-be-transmitted information sent by the terminal to the network device. The terminal may filter the to-be-transmitted information, and send, to the network device, data (that is not encoded or high-fidelity encoded) of high value for training the AI codec. This can improve generalization of the AI codec. A specific example is shown in FIG. 11 below.

FIG. 11 is a schematic flowchart of a filtering method according to an embodiment of this application. The method is applied to the communication system shown in FIG. 1, or is applied to the scenario shown in FIG. 2. A terminal in the method may be the terminal 100 shown in FIG. 3. A network device in the method may be the network device 200 shown in FIG. 4. The method may include but is not limited to the following steps.

S701: The network device sends first configuration information to the terminal.

Specifically, S701 is optional. For a description of the first configuration information, refer to the description of S101 in FIG. 5. Optionally, the first configuration information may further include a determining criterion used by the terminal to determine whether to send to-be-transmitted information, and the determining criterion may be a hard decision criterion or a soft decision criterion. Optionally, if the hard decision criterion is used, the terminal may directly determine, based on whether the to-be-transmitted information is applicable to an AI codec, whether to send the to-be-transmitted information. Optionally, if the soft decision criterion is used, the terminal may determine a sending probability of the to-be-transmitted information according to a preset rule, and then send the to-be-transmitted information based on the sending probability. Optionally, the first configuration information may further include the preset rule, for example, a mapping relationship (for example, a proportional relationship, where the mapping relationship may be represented by a function and/or a parameter) between a related parameter obtained in a determining process (for example, a cosine similarity, a probability parameter, or an output of an AI decider) and a sending probability. Optionally, the preset rule is pre-configured by the terminal and the network device through negotiation.

S702: The terminal determines, based on the first configuration information, to send eighth information.

Specifically, S702 is optional. Optionally, the terminal may determine, based on the first configuration information, whether the to-be-transmitted information can be sent, that is, whether the to-be-transmitted information has high value for training the AI codec. Optionally, to improve generalization of the AI codec, when the AI codec is trained, an input needs to be set to data that is not identically distributed as an existing training data set. That is, data that is not applicable to the AI codec is more valuable for training the AI codec.

Optionally, if the determining criterion that is used by the terminal to determine whether to send the to-be-transmitted information and that is in the first configuration information is the hard decision criterion, the terminal may determine, based on the first configuration information, whether the to-be-transmitted information is applicable to the AI codec, and if the to-be-transmitted information is not applicable the AI codec, the terminal may send the to-be-transmitted information to the network device, where a determining method is similar to the determining method shown in S102 in FIG. 5, but a required determining result is opposite. Optionally, if the determining criterion that is used by the terminal to determine whether to send the to-be-transmitted information and that is in the first configuration information is the soft decision criterion, the terminal may determine, based on the preset rule and based on the related parameter obtained in the determining process, the sending probability of the to-be-transmitted information. A larger related parameter indicates a lower sending probability. Specific determining examples are as follows.

Example 1: It is assumed that the first configuration information is shown in Case 2 in S101, and includes the mean of the training data set on which the first preprocessing is performed. N is equal to 1, and the group of determining thresholds that are predefined or indicated in the first configuration information includes one determining threshold $CS_t$. The terminal may first perform the first preprocessing on the to-be-transmitted information, and then compute a cosine similarity $CS_0$ between the mean and information after the first preprocessing. If the determining criterion in the first configuration information is the hard decision criterion, when $CS_0 \leq CS_t$, the terminal may determine that the to-be-transmitted information is not applicable to the AI codec, that is, there is high value for training the AI codec. Therefore, the terminal may determine to send the to-be-transmitted information. Otherwise, the terminal determines to not send the to-be-transmitted information. If the determining criterion in the first configuration information is the soft decision criterion, the terminal may determine the sending probability of the to-be-transmitted information based on the cosine similarity $CS_0$ obtained through computing. For example, if $CS_0 \leq CS_t$, the to-be-transmitted information is sent with a probability P1; or if $CS_0 > CS_t$, the to-be-transmitted information is sent with a probability P2, where P2<P1. Alternatively, the sending probability P = $(1 - CS_0)/2$ is obtained through computing according to the preset rule, where because a value range of $CS_0$ is [-1, 1], a value range of P is [0, 1]. Then, the terminal may determine, based on sampling of the sending probability P, whether to send the to-be-transmitted information. Alternatively, the terminal may send the sending probability P to the network device, and the network device determines, based on sampling of the sending probability P, whether the terminal is allowed to send the eighth information. For example, when a sampling value represents sending, the to-be-transmitted information is sent; otherwise, the to-be-transmitted information is not sent.

Example 2: It is assumed that the first configuration information is shown in Case 1 in S101, and includes the complete distribution parameter of the mathematical distribution of the training data set. N is equal to 1, and the group of determining thresholds that are predefined or indicated in the first configuration information includes two determining thresholds $PDF_{t1}$ and $PDF_{t2}$. The terminal may compute a PDF of the to-be-transmitted information in the mathematical distribution, namely, $PDF_0$. If the determining criterion in the first configuration information is the hard decision criterion, when $PDF_{t1} \leq PDF_0 \leq PDF_{t2}$, the terminal may determine that the to-be-transmitted information is applicable to the AI codec, but there is poor expected effect of applying the AI codec to perform encoding and decoding on the to-be-transmitted information; and if $PDF_0 > PDF_{t2}$, the terminal may determine that the to-be-transmitted information is applicable to the AI codec, and there is good expected effect of applying the AI codec to perform encoding and decoding on the to-be-transmitted information. In both cases, the terminal may determine not to send the to-be-transmitted information. If $PDF_0 < PDF_{t1}$, the terminal may determine that the to-be-transmitted information is not applicable to the AI codec, that is, the to-be-transmitted information is information of high value for training the AI codec. Therefore, the terminal may determine to send the to-be-transmitted information. If the determining criterion in the first configuration information is the soft decision criterion, the terminal may determine, according to the preset rule, the sending probability of the to-be-transmitted information. For example, if $PDF_0 < PDF_{t1}$, the to-be-transmitted information is sent with a probability P1; if $PDF_{t1} \leq PDF_0 \leq PDF_{t2}$, the to-be-transmitted information is sent with a probability P2; and if $PDF_0 > PDF_{t2}$, the to-be-transmitted information is sent with a probability P3, where P3<P2<P1. Alternatively, the sending probability obtained through computing according to a preset rule is

$$P = (1 - {PDF_0}/{PDF_{max}})$$

where a value range of $PDF_0$ is [0, $PDF_{max}$], $PDF_{max}$ is a largest value of PDFs in the mathematical distribution, and correspondingly, a value range of P is [0, 1]. Then, the terminal may determine, based on sampling of the sending probability P, whether to send the to-be-transmitted information. Alternatively, the terminal may send the sending probability P to the network device, and the network device determines, based on sampling of the sending probability P, whether the terminal is allowed to send the to-be-transmitted information. For example, when a sampling value represents sending, the to-be-transmitted information is sent; otherwise, the to-be-transmitted information is not sent.

Example 3: It is assumed that the first configuration information is shown in Case 3 in S101, and N is greater than 1. The terminal may set the input of the AI decider as the to-be-transmitted information, so as to obtain the outputs $I_1$, $I_2$, ... , $I_N$ of the N output ports of the AI decider. If the determining criterion in the first configuration information is the hard decision criterion, for an AI codec corresponding to an $i^{th}$ output port, if $I_i \leq$ Output threshold $I_t$, where a value range of i is [1, N], the terminal may determine that the to-be-transmitted information is not applicable to the AI codec, that is, there is high value for training the AI codec. Therefore, the terminal can determine to send the to-be-transmitted information. If the determining criterion in the first configuration information is the soft decision criterion, and for an AI codec corresponding to an $i^{th}$ output port, $I_i$ is a probability that the to-be-transmitted information is applicable to the AI codec, the sending probability that is of the to-be-transmitted information and that is obtained through computing according to the preset rule is $P = 1 - I_i$, where a value range of P is [0, 1]. Then, the terminal may determine, based on sampling of the sending probability P, whether to send the to-be-transmitted information. Alternatively, the terminal may send the sending probability P to the network device, and the network device determines, based on sampling of the sending probability P, whether the terminal is allowed to send the to-be-transmitted information. For example, when a sampling value represents sending, the to-be-transmitted information is sent; otherwise, the to-be-transmitted information is not sent.

Optionally, it is assumed that the terminal determines that the eighth information is data of high value for training the AI codec. Therefore, the terminal can request the network device to send the eighth information, that is, perform S702.

S703: The terminal sends first notification information to the network device.

Specifically, S703 is optional. Optionally, the first notification information may be used to request the network device to send data, for example, request a transmission resource. Optionally, the first notification information may specifically include a determining result obtained in the determining process (namely, S702), that is, the to-be-transmitted eighth information is of high value for training the AI codec. Optionally, the first notification information may specifically include the sending probability obtained in the determining process (namely, S702). Optionally, the first notification information may specifically include the related parameter obtained in the determining process (namely, S702), for example, the cosine similarity, the probability parameter (for example, $PDF_0$ or $PMF_0$), and the output of the AI decider that are obtained through computing.

S704: The network device sends second notification information to the terminal in response to the first notification information.

Specifically, S704 is optional. Optionally, the network device may determine, with reference to the first notification information (for example, including the determining result obtained in S702, the sending probability, and/or the related parameter) and an actual situation such as resource usage (for example, whether there is an available uplink transmission resource), whether the terminal is allowed to send the data. For example, the first notification information includes the determining result obtained in S702, and when determining that a transmission resource is available, the network device may allow the terminal to send the data; the first notification information includes the sending probability obtained in S702, and the network device may determine, based on sampling of the sending probability, whether to allow the terminal to send the eighth information; or the first notification information includes the related parameter obtained in S702, and the network device may determine, based on the related parameter reported by the terminal, whether the eighth information is the data of high value for training the AI codec, that is, whether the information can be sent. A determining manner may be the same as a determining process shown in S702, and a difference lies in S702, that the terminal may compute only the related parameter, but does not determine whether the eighth information is the data of high value for training the AI codec, that is, in S702, the determining result may not be obtained. On the basis of the foregoing description, when the uplink transmission resource is available, the network device may allow the terminal to send the eighth information. Optionally, the second notification information may indicate that the terminal is allowed to send the data, and optionally, information about the transmission resource allocated by the network device to the terminal, for example, an identifier of a transmission frequency band. Optionally, the second notification information may also indicate that the terminal is refused to send the data. Optionally, when receiving the second notification information, the terminal may cancel sending the data.

S705: The terminal sends the eighth information to the network device.

Optionally, it is assumed that the second notification information indicates that the terminal is allowed to send the data, the terminal may send the unencoded eighth information or the high-fidelity encoded eighth information to the network device, to ensure data integrity and improve accuracy of training the AI codec.

S706: The terminal determines, based on the first configuration information, not to send ninth information.

Specifically, S706 is optional. Optionally, S702 to S705 may be a first time that the terminal determines whether to send the to-be-transmitted information after obtaining the first configuration information, where the determining result is determining to send the to-be-transmitted information. S706 may be a second time that the terminal determines whether to send the to-be-transmitted information after obtaining the first configuration information, where a determining result is determining not to send the to-be-transmitted information. Optionally, in specific implementation, the terminal may continuously obtain the to-be-transmitted information, and perform determining for a plurality of times periodically or in a triggering manner, that is, determine, based on the first configuration information, whether to send the to-be-transmitted information. Each determining is similar to the first determining and the second determining. However, because to-be-transmitted information may be different, a determining result obtained each time may be different, for example, determining to send the information or determining not to send the information.

In the method shown in FIG. 11, there is usually a large amount of to-be-transmitted information, and the terminal can perform filtering on the to-be-transmitted information, to send, to the network device, the data of high value for training the AI codec. This prevents the terminal from sending, to the network device, data of low value for training the AI codec, and avoids waste of uplink bandwidth due to poor performance of the AI codec caused by the unbalanced training data set.

Optionally, information about the AI codec (for example, an identifier of the AI codec) may also be understood as information about an AI encoder (for example, an identifier of an AI encoder) in the AI codec, or may be understood as information of an AI decoder (for example, an identifier of an AI decoder) in the AI codec, or may be understood in an opposite manner.

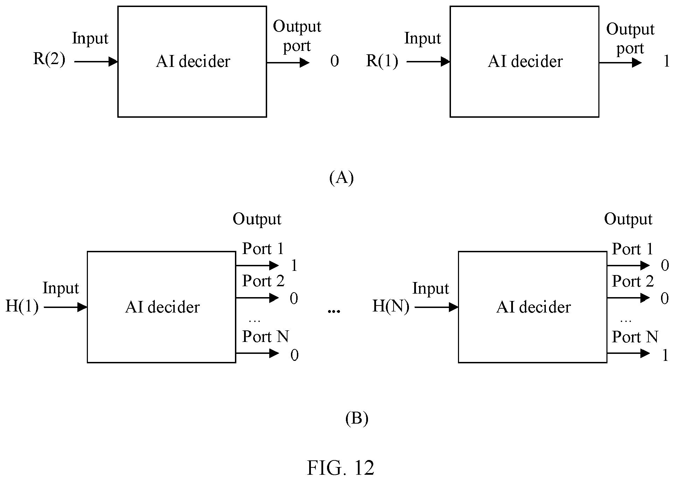

In some embodiments, the AI decider sent by the network device to the terminal may be generated through independent training. A specific example is shown in FIG. 12.

FIG. 12 shows an example of a generation process of an AI decider.

As shown in (A) in FIG. 12, when the AI decider for determining whether to-be-transmitted information is applicable to an AI codec is generated through training, training data sets may be divided into two sets: R(1) and R(2). R(1) may be data that is identically distributed as the training data sets of the AI codec, for example, a set of the training data sets of the AI codec. R(2) may be data that is not identically distributed as the training data sets of the AI codec, for example, a set of training data sets of another AI codec. Optionally, an AI model of the AI decider may be set to at least one layer of neural network. It is assumed that a last layer of the AI model is set to a Sigmoid function, and a value range of an output is [0, 1]. Optionally, an input data type of the AI decider may be set to CSI, and there may be one output port. Optionally, when the AI decider is trained, the output may be set to 1 when an input is set to the data in R(1), and the output may be set to 0 when an input is set to the data in R(2). Optionally, when the AI decider is subsequently used for inference, to-be-transmitted information may be set as the input of the AI decider, so as to obtain the output of the AI decider. A larger output indicates that the to-be-transmitted information is more applicable to the AI codec, that is, there is better effect of applying the AI codec. Optionally, when the output is larger than an output threshold (for example, 0.5), it may represent that the to-be-transmitted information is applicable to the AI encoder; otherwise, it represents that the to-be-transmitted information is not applicable to the AI encoder.

As shown in (B) in FIG. 12, when the AI decider for determining whether to-be-transmitted information is applicable to N AI codecs is generated through training, training data sets may be divided into N sets: H(1), H(2), ..., and H(N). H(i) may be data that is identically distributed as a training data set of an i$^{th}$ AI codec. For example, H(i) is a set of the training data set of the i$^{th}$ AI codec, i is a positive integer, and a value range of i is [1, N]. Optionally, an AI model of the AI decider may be set to at least one layer of neural network. It is assumed that a last layer of the AI model is set to a Softmax function. In this case, a value range of an output of each output port is [0, 1], and a sum of outputs of all ports is 1. Optionally, an input data type of the AI decider may be set to CSI, and there may be N output ports: a port 1, a port 2, ..., a port N, where a port i may correspond to the i$^{th}$ AI codec, that is, an output of the output port i represents whether the to-be-transmitted information is applicable to the i$^{th}$ AI codec. Optionally, when the AI decider is trained, when an input is set to the data in H(i), the output of the output port i may be set to 1, and outputs of other output ports may be set to 0. For example, when an input is data in H(1), an output of an output port 1 is set to 1, and outputs of other (N-1) output ports are set to 0. The AI decider obtained through training in this way may also be understood as an N-classification decider. Optionally, when the AI decider is subsequently used for inference, to-be-transmitted information may be set as the input of the AI decider, so as to obtain outputs of the N output ports of the AI decider. An AI codec to which the to-be-transmitted information is most applicable may be determined by comparing the outputs of the N output ports. For example, when the output of the output port i is larger than an output threshold (for example, 0.5) and larger than the outputs of other (N-1) output ports, it may represent that the to-be-transmitted information is most applicable to the i$^{th}$ AI codec. In other words, a larger output of the output port i represents that the to-be-transmitted information is more applicable to the i$^{th}$ AI codec, that is, there is better expected effect of applying the i$^{th}$ AI codec to perform encoding and decoding on the to-be-transmitted information.

Optionally, A "greater than" B may also be replaced with (-A) "less than" (-B). In addition, the foregoing "greater than" a threshold may also be replaced with "greater than or equal to", or may be replaced in a reverse manner. Similarly, the foregoing "less than" a threshold may also be replaced with "less than or equal to", or may be replaced in a reverse manner.

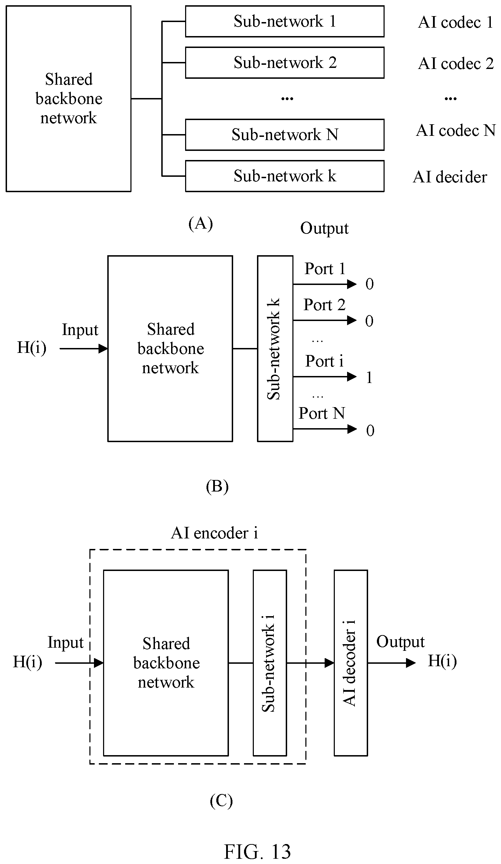

In some embodiments, the AI decider sent by the network device to the terminal may be obtained through transfer learning. A specific example is shown in FIG. 13.

FIG. 13 shows an example of a generation process of another AI decider.

As shown in (A) in FIG. 13, optionally, N AI encoders (an AI encoder 1, an AI encoder 2, ..., and an AI encoder N) and the AI decider share one shared backbone network. Optionally, an AI codec may be first trained by using all data, and then some shallow layers of a network (for example, first F layers of the network, where F is a positive integer and F is less than a total quantity of layers in the AI encoder) of an AI encoder in the AI codec is retained to be used as a shared backbone network. Optionally, the shared backbone network remains unchanged (that is, a parameter is not updated in subsequent training), then different AI encoder sub-networks and AI decoders are separately connected, and training data sets corresponding to the AI codecs are used to generate final AI codecs. Optionally, the shared backbone network remains unchanged, and an AI decider sub-network is subsequently connected, and all data is used for training to generate an N-classification decider (namely, the AI decider). That is, training of the shared backbone network needs to be completed before training of each sub-network. Optionally, when the AI decider is generated through training, a sub-network k may be trained when the shared backbone network is kept unchanged. For a specific example, refer to (B) in FIG. 13. When an AI codec i is generated through training, a sub-network i (corresponding to the AI encoder i) and an AI decoder i may be trained when the shared backbone network is kept unchanged. For a specific example, refer to (C) in FIG. 13, where i is a positive integer, and a value range of i is [1, N].

For example, the shared backbone network may include at least one layer (optionally, any layer may be a module including a plurality of layers). The sub-network can be one layer (optionally, this layer may also be a module including a plurality of layers).

As shown in (B) in FIG. 13, optionally, when the AI decider is trained, a last layer of the sub-network k may be set to a Softmax function. When the AI decider is trained, when an input is set to data in H(i), an output of an output port i may be set to 1, and outputs of other output ports may be set to 0. For example, when an input is data in H(N), an output of an output port N is set to 1, and outputs of other (N-1) output ports are set to 0. Optionally, in a training process, only a parameter of the sub-network k is updated, and a parameter of the shared backbone network is not updated. Optionally, when the AI decider is subsequently used for inference, to-be-transmitted information may be set as the input of the AI decider, so as to obtain outputs of the N output ports of the AI decider. An AI encoder to which the to-be-transmitted information is most applicable may be determined by comparing the outputs of the N output ports. For a specific example, refer to the description in (B) in FIG. 12.

As shown in (C) in FIG. 13, optionally, the AI encoder i and the corresponding AI decoder i in a same group perform training together, to form a large AI model. Optionally, when the AI model is trained, an input is set to H(i), and an output is also set to H(i), that is, input data and output data are the same. Optionally, in a training process, only parameters of the sub-network i and the AI decoder i are updated, and the parameter of the shared backbone network is not updated. After the training of the AI model is completed, the corresponding AI encoder i and AI decoder i may be obtained.

In some embodiments, when the AI decider is trained, second preprocessing may be performed on a training data set, and then data after the second preprocessing is used as the input of the AI decider. Optionally, during inference, second preprocessing may be performed on the to-be-transmitted information first, and then information after the second preprocessing is used as the input of the AI decider to obtain the output.

In this application, after the network device sends the AI decider or any AI encoder to the terminal, if subsequently sending the AI decider or another AI encoder to the terminal, the network device may send only a corresponding sub-network, and does not need to send the entire AI model. This reduces transmission resources. In addition, if the terminal determines, by using the AI decider, whether there is an AI encoder to which any to-be-transmitted information (information B for short) is applicable, that is, information B is processed by using the shared backbone network (information after the processing is referred to as information C for short), when the terminal subsequently encodes the information B by using any AI encoder, the terminal does not need to process the information B by using the entire AI model of the AI encoder, but directly inputs the information C into the sub-network corresponding to the AI encoder. This greatly reduces a computation amount.

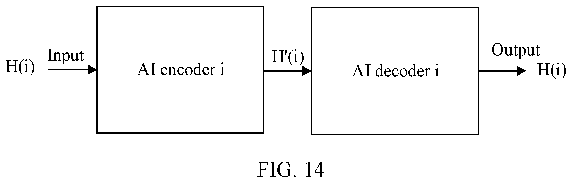

This is not limited to the embodiment shown in (C) in FIG. 13. In specific implementation, the AI codec may also be generated through independent training. A specific example is shown in FIG. 14.

FIG. 14 shows an example of a generation process of an AI codec.

As shown in FIG. 14, optionally, an AI encoder i and a corresponding AI decoder i in the same group are trained together, to form a large AI model. For example, the AI model is CsiNet for CSI encoding and decoding. Optionally, when the AI model is trained, an input (also an input of the AI encoder i) is set to H(i), and an output (also the AI decoder i) is also set to H(i), that is, input data and output data are the same. Optionally, H(i) may be CSI or preprocessed CSI, and an output $H'(i)$ of the AI encoder may be encoding information of the CSI or an index corresponding to the encoding information. Compared with H(i), a dimension of $H'(i)$ is greatly reduced. Optionally, the output $H'(i)$ of the AI encoder may be used as an input of the AI decoder, and the output is the recovered CSI. In a training process, parameters of both the AI encoder i and the AI decoder i may be updated, or only a parameter of the AI encoder i or the AI decoder i may be updated based on a requirement. After training of the AI model is completed, the corresponding AI encoder i and AI decoder i may be obtained.

For example, it is assumed that the network device is a base station. After entering a coverage area of the base station, the terminal establishes a connection to the base station. After the connection, the base station may send the first configuration information to the terminal. When the connection to the base station is maintained, it is assumed that the terminal is located in a geographical location A and indoors at a first moment, and in this case, the terminal needs to send first CSI to the base station. The terminal may determine, based on the first configuration information, whether there is an AI encoder to which the first CSI is applicable. It is assumed that the first CSI is most applicable to the first AI encoder, the terminal may send, to the base station, information for requesting to configure the first AI encoder, and then encode the first CSI by using the first AI encoder. Then, the terminal may send the encoded CSI and information indicating that the first AI encoder is used to the base station, and the base station may obtain the first CSI that is reported by the terminal and that is decoded by using an AI decoder corresponding to the first AI encoder. The terminal may move. It is assumed that the terminal is located in a geographical location B and outdoors at a second moment, and in this case, the terminal needs to send second CSI to the base station. The terminal may determine, based on the first configuration information, whether there is an AI encoder to which the second CSI is applicable. It is assumed that there is no AI encoder to which the second CSI is applicable, the terminal may encode the second CSI by using the standby encoder. Then, the terminal may send the encoded CSI and information indicating that the standby encoder is used to the base station, and the base station may obtain the second CSI that is reported by the terminal and that is decoded by using a standby decoder corresponding to the standby encoder.

This is not limited to the foregoing enumerated cases. In specific implementation, the information about the AI codec (for example, the first configuration information) and the AI encoder that are received by the terminal may not be sent by the network device, but are sent by another device. For example, when the network device is a core network device, the information about the AI codec and the AI encoder may be first sent to the base station, and then the base station sends the information about the AI codec and the AI encoder to the terminal based on an actual situation.

Optionally, the input of the AI encoder may be the to-be-transmitted information of the terminal, or may be the information obtained after the first preprocessing is performed on the to-be-transmitted information of the terminal, or may be obtained after other processing is performed on the to-be-transmitted information of the terminal, for example, a precoding matrix indicator (precoding matrix indicator, PMI) obtained after matrix decomposition is performed on the CSI, or a correlation matrix of the CSI. This is not limited in this application.

Optionally, the input of the AI decider may be the to-be-transmitted information of the terminal, or may be the information obtained after the second preprocessing is performed on the to-be-transmitted information of the terminal, or may be obtained after other processing is performed on the to-be-transmitted information of the terminal, for example, a PMI obtained after matrix decomposition is performed on the CSI, or a correlation matrix of the CSI. This is not limited in this application.

This is not limited to the AI decider described above. In specific implementation, some modules in the AI decider may be AI models, and other module may be another processing module, that is, some or all modules in the AI decider are AI models.

This is not limited to the foregoing enumerated cases. During specific implementation, the terminal in embodiments of this application may alternatively be another device, for example, a base station or a core network device. For related descriptions such as performing operations, refer to the description of the terminal. Similarly, the network device may also be another device, for example, a terminal. For related descriptions such as performing operations, refer to the description of the network device.

A person of ordinary skill in the art may understand that all or some of the procedures of the methods in the foregoing embodiments may be implemented by a computer program instructing related hardware. The computer program may be stored in a computer-readable storage medium. When the computer program is run, the procedures in the foregoing method embodiments are performed. The storage medium includes any medium that can store computer program code, such as a read-only memory (read-only memory, ROM), a random access memory (random access memory, RAM), a magnetic disk, or an optical disc.

## Claims

1. An information encoding control method, applied to a terminal, wherein the method comprises:

   receiving first configuration information, wherein the first configuration information is used to configure N groups of parameters of N AI encoders, and N is a positive integer greater than 1; and sending first indication information to a network device, wherein the first indication information indicates that a first encoder is used for encoding first information, the first encoder is determined based on the N groups of parameters and the first information, and the first encoder is an encoder in the N AI encoders, or the first encoder is a second encoder different from the N AI encoders.

2. The method according to claim 1, wherein the method further comprises: sending second information, wherein the second information is determined by encoding the first information by the first encoder.

3. The method according to claim 1 or 2, wherein the first encoder is determined based on a relationship between a first determining parameter and a first determining threshold, the first determining parameter is determined based on the N groups of parameters and the first information, and the first determining parameter is a cosine similarity CS, a probability density function PDF, a probability mass function PMF, or a Euclidean distance.

4. The method according to any one of claims 1 to 3, wherein the first information is channel state information CSI or uplink data.

5. An information encoding control method, applied to a terminal, wherein the method comprises:

receiving first configuration information, wherein the first configuration information is used to configure an AI decider, the AI decider is configured to determine an AI encoder that is in N AI encoders and to which first information is applicable, and/or is configured to determine that none of the N AI encoders is applicable to encoding the first information, and N is a positive integer greater than 1; and
sending first indication information to a network device, wherein the first indication information indicates that a first encoder is used for encoding the first information, the first encoder is determined based on the AI decider and the first information, and the first encoder is an encoder in the N AI encoders, or the first encoder is a second encoder different from the N AI encoders.

6. The method according to claim 5, wherein the method further comprises: sending second information, wherein the second information is determined by encoding the first information by the first encoder.

7. The method according to claim 5 or 6, wherein the first encoder is determined based on an output of the AI decider, and the output of the AI decider is obtained based on the first information and the AI decider.

8. The method according to any one of claims 5 to 7, wherein the first information is channel state information CSI or uplink data.

9. An information encoding control method, applied to a terminal, wherein the method comprises:

receiving first configuration information, wherein the first configuration information is used to configure a parameter of a first AI encoder; and
sending first indication information to a network device, wherein the first indication information indicates that a first encoder is used for encoding first information, the first encoder is determined based on the parameter of the first AI encoder and the first information, and the first encoder is the first AI encoder or the first encoder is a second encoder different from the first AI encoder.

10. The method according to claim 9, wherein the method further comprises: sending second information, wherein the second information is determined by encoding the first information by the first encoder.

11. The method according to claim 8 or 9, wherein the first encoder is determined based on a relationship between a first determining parameter and a first determining threshold, the first determining parameter is determined based on the parameter of the first AI encoder and the first information, and the first determining parameter is a cosine similarity CS, a probability density function PDF, a probability mass function PMF, or a Euclidean distance.

12. The method according to any one of claims 9 to 11, wherein the first information is channel state information CSI or uplink data.

13. An information encoding control method, applied to a terminal, wherein the method comprises:

receiving first configuration information, wherein the first configuration information is used to configure an AI decider, and the AI decider is configured to determine that a first AI encoder is applicable to encoding first information, and/or is configured to determine that the first AI encoder is not applicable to encoding the first information; and
sending first indication information to a network device, wherein the first indication information indicates that a first encoder is used for encoding the first information, the first encoder is determined based on the AI decider and the first information, and the first encoder is the first AI encoder or the first encoder is a second encoder different from the first AI encoder.

14. The method according to claim 13, wherein the method further comprises: sending second information, wherein the second information is determined by encoding the first information by the first encoder.

15. The method according to claim 13 or 14, wherein the first encoder is determined based on an output of the AI decider, and the output of the AI decider is obtained based on the first information and the AI decider.

16. The method according to any one of claims 13 to 15, wherein the first information is channel state information CSI or uplink data.

17. An information encoding control method, applied to a network device, wherein the method comprises:

sending first configuration information to a terminal, wherein the first configuration information is used to configure N groups of parameters of N AI encoders; and
receiving first indication information and second information, wherein the second information is determined by the terminal based on first information and a first encoder, the first indication information indicates that the first encoder is used for encoding the first information, the first encoder is determined based on the N groups of parameters and the first information, and the first encoder is an encoder in the N AI encoders, or the first encoder is a second encoder different from the N AI encoders.

18. The method according to claim 17, wherein the method further comprises: decoding the second information by using a first decoder corresponding to the first encoder.

19. The method according to claim 17 or 18, wherein the first encoder is determined based on a relationship between a first determining parameter and a first determining threshold, the first determining parameter is determined based on the N groups of parameters and the first information, and the first determining parameter is a cosine similarity CS, a probability density function PDF, a probability mass function PMF, or a Euclidean distance.

20. The method according to any one of claims 17 to 19, wherein the first information is channel state information CSI or uplink data.

21. An information encoding control method, applied to a network device, wherein the method comprises:

   sending first configuration information to a terminal, wherein the first configuration information is used to configure an AI decider, and the AI decider is configured to determine an AI encoder that is in N AI encoders and to which first information is applicable, and/or is configured to determine that none of the N AI encoders is applicable to encoding the first information; and receiving first indication information and second information, wherein the second information is determined by the terminal based on the first information and a first encoder, the first indication information indicates that the first encoder is used for encoding the first information, the first encoder is determined based on the AI decider and the first information, and the first encoder is an encoder in the N AI encoders, or the first encoder is a second encoder different from the N AI encoders.

22. The method according to claim 21, wherein the method further comprises: decoding the second information by using a first decoder corresponding to the first encoder.

23. The method according to claim 21 or 22, wherein the first encoder is determined based on an output of the AI decider, and the output of the AI decider is obtained based on the first information and the AI decider.

24. The method according to any one of claims 21 to 23, wherein the first information is channel state information CSI or uplink data.

25. A terminal, comprising a transceiver, a processor, and a memory, wherein the memory is configured to store a computer program, and the processor invokes the computer program to perform the method according to any one of claims 1 to 16.

26. A network device, comprising a transceiver, a processor, and a memory, wherein the memory is configured to store a computer program, and the processor invokes the computer program to perform the method according to any one of claims 17 to 24.

27. A computer storage medium, wherein the computer storage medium stores a computer program, and when the computer program is executed by a processor, the method according to any one of claims 1 to 16 or any one of claims 17 to 24 is implemented.

28. A computer program product, wherein when the computer program product runs on an electronic device, the electronic device is enabled to perform the method according to any one of claims 1 to 16 or any one of claims 17 to 24.

FIG. 1

(A)

(B)

FIG. 2

FIG. 3

FIG. 4

FIG. 5

```
┌─────────────────────────┐          ┌─────────────────────────┐
│     Network device      │          │        Terminal         │
└─────────────────────────┘          └─────────────────────────┘
```

S201: Send D AI encoders

S202: Send first configuration information

S203: Determine, based on the first configuration information, that first information is applicable to a first AI encoder in the D AI encoders

S204: Encode the first information by using the first AI encoder to obtain fifth information

S205: Send the fifth information and third indication information

S206: Determine, based on the third indication information, a first AI decoder corresponding to the first AI encoder

S207: Decode the fifth information by using the first AI decoder

...

FIG. 6

| Network device | | Terminal |
|---|---|---|

S301: Send first configuration information

S302: Determine, based on the first configuration information, that first information is applicable to a first AI encoder

S303: Send fourth indication information

S304: Send the first AI encoder in response to the fourth indication information

S305: Encode the first information by using the first AI encoder to obtain fifth information

S306: Send the fifth information and third indication information

S307: Determine, based on the third indication information, a first AI decoder corresponding to the first AI encoder

S308: Decode the fifth information by using the first AI decoder

...

FIG. 7

| Network device | Terminal |
|---|---|

S401: Send first configuration information →

S402: Determine, based on the first configuration information, that first information is applicable to a first AI encoder

S403: Encode the first information by using a standby encoder to obtain sixth information

S404: Send the sixth information and fifth indication information ←

S405: Send fourth indication information ←

S406: Send the first AI encoder in response to the fourth indication information →

S407: Determine, based on the fifth indication information, a standby decoder corresponding to the standby encoder

S408: Decode the sixth information by using the standby decoder

...

FIG. 8

| Network device | Terminal |
|---|---|

S501: Send first configuration information

S502: Determine, based on the first configuration information, that there is no AI encoder to which first information is applicable

S503: Encode the first information by using a standby encoder to obtain sixth information

S504: Send the sixth information and fifth indication information

S505: Determine, based on the fifth indication information, a standby decoder corresponding to the standby encoder

S506: Decode the sixth information by using the standby decoder

...

FIG. 9

| Network device | Terminal |
|---|---|

S601: Send first configuration information →

S602: Determine, based on the first configuration information, whether there is an AI encoder to which first information is applicable

S603: Send first determining information ←

S604: Determine a third encoder based on the first determining information

S605: Send sixth indication information and the third encoder →

S606: Encode the first information by using the third encoder to obtain seventh information

S607: Send the seventh information ←

S608: Decode the seventh information by using a third decoder corresponding to the third encoder

...

FIG. 10

| Network device | Terminal |
|---|---|

S701: Send first configuration information

S702: Determine, based on the first configuration information, to upload eighth information

S703: Send first notification information

S704: Send second notification information in response to the first notification information

S705: Send the eighth information

**First determining**

S706: Determine, based on the first configuration information, not to upload ninth information

**Second determining**

...

FIG. 11

FIG. 12

| Shared backbone network | Sub-network 1 | AI codec 1 |
| | Sub-network 2 | AI codec 2 |
| | ... | ... |
| | Sub-network N | AI codec N |
| | Sub-network k | AI decider |

(A)

Output

H(i) → Input → Shared backbone network → Sub-network k →
Port 1 → 0
Port 2 → 0
...
Port i → 1
...
Port N → 0

(B)

AI encoder i

H(i) → Input → Shared backbone network → Sub-network i → AI decoder i → Output → H(i)

(C)

FIG. 13

FIG. 14

## INTERNATIONAL SEARCH REPORT

| International application No. |
|---|
| **PCT/CN2022/075987** |

**A. CLASSIFICATION OF SUBJECT MATTER**

H04L 1/00(2006.01)i; G10L 19/00(2013.01)i

According to International Patent Classification (IPC) or to both national classification and IPC

**B. FIELDS SEARCHED**

Minimum documentation searched (classification system followed by classification symbols)

H04L; G10L

Documentation searched other than minimum documentation to the extent that such documents are included in the fields searched

Electronic data base consulted during the international search (name of data base and, where practicable, search terms used)

CNABS, CNTXT, VEN, USTXT, WOTXT, EPTXT, CNKI: 自动编码, 自编码, 智能编码, AI编码, 编码器, 编码模型, 解码器, 解码模型, 选择, 选用, 配置, 参数, 训练, 样本, 网络, 基站, 手机, 终端, 移动台, 备用, 备选, 合适, 适用, 匹配, 适配; autoencoder, AE, auto, encoder, AI, choose, base station, BS, configuration, parameter, alternative, terminal, mobile station, MS, decoder

**C. DOCUMENTS CONSIDERED TO BE RELEVANT**

| Category* | Citation of document, with indication, where appropriate, of the relevant passages | Relevant to claim No. |
|---|---|---|
| Y | CN 1237073 A (KONINKLIJKE PHILIPS ELECTRONICS N.V.) 01 December 1999 (1999-12-01) description page 3 line 12 - page 7 line 9 and figures 1-6 | 1-28 |
| Y | WO 2020035684 A1 (IMPERIAL COLLEGE OF SCIENCE, TECHNOLOGY AND MEDICINE) 20 February 2020 (2020-02-20) description paragraph [0148] | 1-28 |
| A | CN 111656697 A (QUALCOMM INC.) 11 September 2020 (2020-09-11) entire document | 1-28 |
| A | CN 112367675 A (INNER MONGOLIA UNIVERSITY) 12 February 2021 (2021-02-12) entire document | 1-28 |
| A | US 2019303766 A1 (FUJITSU LTD.) 03 October 2019 (2019-10-03) entire document | 1-28 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **02 April 2022** | **19 April 2022** |

| Name and mailing address of the ISA/CN | Authorized officer |
|---|---|
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

| International application No. |
| --- |
| **PCT/CN2022/075987** |

| Patent document cited in search report | | | Publication date (day/month/year) | Patent family member(s) | | | Publication date (day/month/year) |
| --- | --- | --- | --- | --- | --- | --- | --- |
| CN | 1237073 | A | 01 December 1999 | EP | 0961264 | A1 | 01 December 1999 |
| | | | | ES | 2235431 | T3 | 01 July 2005 |
| | | | | US | 2002069075 | A1 | 06 June 2002 |
| | | | | JP | 2000091922 | A | 31 March 2000 |
| | | | | DE | 69922582 | D1 | 20 January 2005 |
| | | | | KR | 19990088502 | A | 27 December 1999 |
| | | | | US | 6499008 | B2 | 24 December 2002 |
| | | | | EP | 0961264 | B1 | 15 December 2004 |
| | | | | CN | 1192656 | C | 09 March 2005 |
| | | | | DE | 69922582 | T2 | 06 October 2005 |
| | | | | KR | 587431 | B1 | 09 June 2006 |
| WO | 2020035684 | A1 | 20 February 2020 | GB | 201813353 | D0 | 26 September 2018 |
| | | | | GB | 2576702 | A | 04 March 2020 |
| CN | 111656697 | A | 11 September 2020 | US | 2021036745 | A1 | 04 February 2021 |
| | | | | EP | 3744012 | A1 | 02 December 2020 |
| | | | | WO | 2019144929 | A1 | 01 August 2019 |
| | | | | WO | 2019144377 | A1 | 01 August 2019 |
| | | | | IN | 202047025233 | A | 02 October 2020 |
| | | | | US | 11211978 | B2 | 28 December 2021 |
| CN | 112367675 | A | 12 February 2021 | None | | | |
| US | 2019303766 | A1 | 03 October 2019 | JP | 2019175176 | A | 10 October 2019 |

Form PCT/ISA/210 (patent family annex) (January 2015)

**EP 4 283 894 A1**

## REFERENCES CITED IN THE DESCRIPTION

### Patent documents cited in the description

- CN 202110206769

- CN 202110376449